# EUROPEAN PATENT SPECIFICATION

(11) **EP 2 449 590 B1**
(45) Date of publication and mention of the grant of the patent: **02.09.2015**
(21) Application number: 09785981.3
(22) Date of filing: 02.07.2009
(51) Int. Cl.: H01L 27/146

(54) **LIGHT GUIDE ARRAY FOR AN IMAGE SENSOR**
LICHTLEITERANORDNUNG FÜR EINEN BILDSENSOR
MATRICE DE GUIDES DE LUMIÈRE POUR CAPTEUR D'IMAGE

(43) Date of publication of application: 09.05.2012
(73) Proprietor: CANDELA MICROSYSTEMS (S) PTE. LTD., Singapore 319637 (SG); Tay, Hiok Nam, Singapore 730409 (SG)
(72) Inventor: TAY, Hiok, Nam, 730409 Singapore (SG); DO, Thanh, Trung, 916502 Singapore (SG)
(74) Representative: ZBM Patents - Zea, Barlocci & Markvardsen
(86) International application number: PCT/IB2009/006148
(87) International publication number: WO 2011/001196

(56) References cited:
- EP-A1- 1 577 950
- GB-A- 2 244 175
- JP-A- 2007 150 087
- JP-A- 2009 088 415
- US-A1- 2006 158 547
- US-A1- 2007 040 102
- SHWEKY I ET AL: "A CSP OPTOELECTRONIC PACKAGE FOR IMAGING AND LIGHT DETECTION APPLICATIONS" PROCEEDINGS OF THE SPIE - THE INTERNATIONAL SOCIETY FOR OPTICAL ENGINEERING, SPIE, US, vol. 3650, 1 January 1999 (1999-01-01), pages 63-68, XP000980670 ISSN: 0277-786X

## Description

### BACKGROUND OF THE INVENTION

### 1. Field of the Invention

The subject matter disclosed, generally relates to structures and methods for fabricating solid state image sensors.

### 2. Background Information

Photographic equipment such as digital cameras and digital camcorders may contain electronic image sensors that capture light for processing into still.or video images. Electronic image sensors typically contain millions of light capturing elements such as photodiodes.

Solid state image sensors can be either of the charge coupled device (CCD) type or the complimentary metal oxide semiconductor (CMOS) type. In either type of image sensor, photo sensors are formed in a substrate and arranged in a two-dimensional array. Image sensors typically contain millions of pixels to provide a high-resolution image.

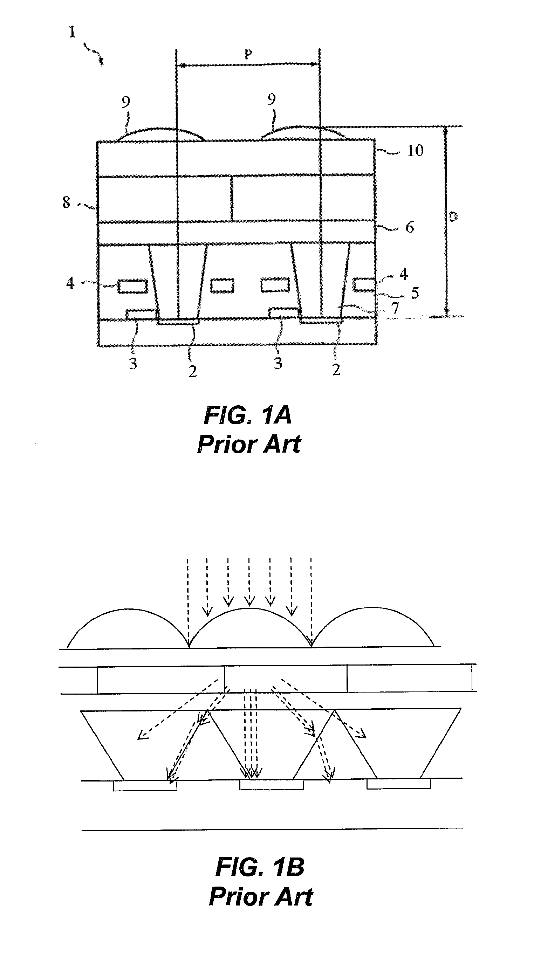

Figure 1A shows a sectional view of a prior art solid-state image sensor 1 showing adjacent pixels in a CMOS type sensor, reproduced from U.S. Pat. No. 7,119,319. Each pixel has a photoelectric conversion unit 2. Each conversion unit 2 is located adjacent to a transfer electrode 3 that transfers charges to a floating diffusion unit (not shown). The structure includes wires 4 embedded in an insulating layer 5. The sensor typically includes a flattening layer 6 below the color filter 8 to compensates for top surface irregularities due to the wires 4, since a flat surface is essential for conventional color filter formation by lithography. A second flattening layer 10 is provided above the color filter 8 to provide a flat surface for the formation of microlens 9. The total thickness of flattening layers 6 and 10 plus the color filter 8 is approximately 2.0um.

Light guides 7 are integrated into the sensor to guide light onto the conversion units 2. The light guides 7 are formed of a material such as silicon nitride that has a higher index of refraction than the insulating layer 5. Each light guide 7 has an entrance that is wider than the area adjacent to the conversion units 2. The sensor 1 may also have a color filter 8 and a microlens 9.

The microlens 9 focuses light onto the photo photoelectric conversion units 2. As shown in Figure 1B because of optical diffraction, the microlens 9 can cause diffracted light that propagates to nearby photoelectric conversion units and create optical crosstalk and light loss. The amount of cross-talk increases when there is a flattening layer above or below the color filter, positioning the microlens farther away from the light guide. Light can crosstalk into adjacent pixels by passing through either flattening layer (above or below color filter) or the color filter's sidewall. Metal shields are sometimes integrated into the pixels to block cross-talking light. In addition, alignment errors between microlens, color filter, and light guide also contribute to crosstalk. The formation, size, and shape of the microlens can be varied to reduce crosstalk. However, extra cost must be added to the precise microlens forming process, and crosstalk still cannot be eliminated.

Backward reflection from the image sensor at the substrate interface is another issue causing loss of light reception. As shown in Fig. 1A, the light guide is in direct contact with the silicon. This interface can cause undesirable backward reflection away from the sensor. Conventional anti-reflection structures for image sensors include the insertion of a oxide-plus-nitride dual-layer film stack directly above the silicon substrate, or a oxynitride layer having variation of nitrogen-to-oxygen ratio there, but only reduces reflection between the silicon substrate and a tall oxide insulator. This approach is not applicable when the interface is silicon substrate and a nitride light guide.

US2007040102 discloses an optical guide for an imager pixel to guide incoming light onto a photosensor of the pixel.

JP2007150087 discloses a solid-state imaging element with an optical wave guide path which shuts and propagates the incident light and leads the incident light to a photoelectric converter.

US2006158547 discloses a solid state imaging device comprising: a semiconductor substrate; a plurality of light receiving elements arranged in a matrix configuration on the semiconductor substrate; a plurality of color filter segments provided above the light receiving elements; and a light collector provided above the color filter segments for collecting light on the light receiving elements. The color filter segments are mutually separated by interstices which contain a gas.

JP2009088415 discloses a solid-state imaging device with a plurality of pixels, and a waveguide for introducing an incident light into the photoelectric converter of the pixel.

EP1577950 discloses a solid-state imaging element including a photo-reception portion and electrode pads, and optical glass bonded onto the solid-state imaging element through a bonding layer.

Article by Shweky I, et al, "A CSP optoelectronic package for imaging and light detection applications", Proceedings of the SPIE - The International Society for Optical Engineering, SPIE, US, vol, 3650, 1 January 1999, pages 63-68, discloses a package for imaging and ligth detection.

### BRIEF SUMMARY OF THE INVENTION

The present invention relates to an image sensor as claimed in claim 1 and a method as claimed in claim 4.

An image sensor pixel that includes a photoelectric conversion unit supported by a substrate and an insulator adjacent to the substrate. The pixel may have a cascaded light guide, wherein a portion of the cascaded light guide is within the insulator and another portion extends above the insulator. The cascaded light guide may include a self-aligned color filter having air-gaps between adjacent color filters. Air-gaps may be sealed from above by a transparent sealing film. The transparent sealing film may have a concave surface over the air-gap to diverge light away from the air-gap into adjacent color filters. The pixel may have an anti-reflection stack between the substrate and the cascaded light guide.

### BRIEF DESCRIPTION OF THE DRAWINGS

Figure 1A is an illustration showing a cross-section of two image sensor pixels of the prior art;
Figure 1B is an illustration showing light cross-talk between adjacent pixels of the prior art;
Figure 2 is an illustration showing a cross-section of two image sensor pixels of an example useful for understanding embodiment of the present invention;
Figure 3A is an illustration showing light traveling along an air gap between two color filters;
Figure 3B is an illustration showing the redirection of light from the air gap into the color filters;
Figure 3C is a graph of light power versus the distance along the air gap ;
Figure 3D is a graph of gap power loss versus gap width versus distance along the air gap of widths 0.6um and 1.0um for three different colors;
Figure 3E is a graph of maximal gap power loss versus gap width at a depth of 1.0um;
Figure 3F is a table of maximal gap power loss for different gap widths at a depth of 1.0um;
Figure 3G is a table of gap area as percentage of pixel area for different gap widths and different pixel pitches;
Figure 3H is a table of pixel power loss for different gap widths and different pixel pitches;
Figure 3I is a graph of pixel power loss versus pixel pitch for different gap widths;
Figures 4A-L are illustrations showing a process used to fabricate the pixels shown in Fig. 2;
Figure 5 is an illustration showing ray traces within the pixel of Fig. 2;
Figure 6A is an illustration showing a pixel at a corner of the array;
Figure 6B is an illustration showing light ray traces within the pixel of Fig. 6A;
Figure 7 is an illustration showing a top view of four pixels within an array;
Figure 8 is an alternate example of the sensor pixels with ray tracing;
Figures 9A-M are illustrations showing a process used to fabricate the pixels shown in Fig. 8;
Figures 10A-H are illustrations showing a process to expose a bond pad;
Figure 11 is an illustration showing an anti-reflection stack within the sensor of an example useful for understanding of the present invention;
Figures 12A-E are illustrations showing an alternate process to form an anti-reflection stack within the sensor of an example useful for understanding of the present invention;
Figure 13A is a graph of transmission coefficient versus light wavelength for an anti-reflection stack;
Figure 13B is a graph of transmission coefficient versus light wavelength for the anti-reflection stack;
Figure 13C is a graph of transmission coefficient versus light wavelength for the anti-reflection stack;
Figures 14A-G are illustrations showing an alternate process to form two anti-reflection stacks within the sensor of an example useful for understanding of the present invention;
Figure 15A is a graph of transmission coefficient versus light wavelength for a first anti-reflection stack on a left hand portion of Fig. 14G;
Figure 15B is a graph of transmission coefficient versus light wavelength for a second anti-reflection stack shown on a right hand portion of Fig. 14G;
Figure 16 is an alternate example of the image sensor ;
Figure 17 is an alternate example of the image sensor ;
Figure 18 is an alternate example of the image sensor
Figure 19 is an alternate example of the image sensor ;
Figure 20 is an illustration showing a process step used to fabricate the pixels shown in Figure 18;
Figures 21A-D are illustrations showing process steps used to fabricate the pixels shown in Figure 19;
Figure 22 is an embodiment of the image sensor of this invention;
Figure 23 is an illustration showing ray traces crossing from cover glass to the light guides in a image sensor package according to an embodiment of this invention;
Figure 24 is an illustration showing a packaging configuration.

### DETAILED DESCRIPTION

Disclosed is an image sensor pixel that includes a photoelectric conversion unit supported by a substrate and an insulator adjacent to the substrate. The pixel includes a light guide that is located within an opening of the insulator and extends above the insulator such that a portion of the light guide has an air interface. The air interface improves the internal reflection of the light guide. Additionally, the light guide and an adjacent color filter are constructed with a process that optimizes the upper aperture of the light guide and reduces crosstalk. These characteristics of the light guide eliminate the need for a microlens. Additionally, an anti-reflection stack is constructed above the photoelectric conversion unit and below the light guide to reduce light loss through backward reflection from the image sensor. Two pixels of different color may be individually optimized for anti-reflection by modifying the thickness of one film within the anti-reflection stack.

The pixel may include two light guides, one above the other. The first light guide is located within a first opening of the insulator adjacent to the substrate. The second light guide is located within a second opening in a support film, which may be eventually removed or partially removed during fabrication of the pixel. A color filter may be located within the same opening and thus self-aligns with the second light guide. The second light guide may be offset from the first light guide at the outer corners of the pixel array to capture light incident at a non-zero angle relative to the vertical axis.

An air gap is created between neighboring color filters by removing the support film material adjacent to the filter. Air has a lower refractive index than the support film and enhances internal reflection within the color filter and the light guide. In addition, the air gap is configured to "bend" light incident on the gap into the color filter and increase the amount of light provided to the sensor.

Reflection at the silicon-light-guide interface is reduced by creating a nitride film and a first oxide film below the first light guide. A second oxide film may be additionally inserted below the nitride film to broaden the range of light frequencies for effective anti-reflection. The first oxide film can be deposited into an etched pit before application of the light-guide material. In an alternate example all anti-reflection films are formed before a pit is etched, and an additional light-guide etch-stop film covers the anti-reflection films to protect them from the pit etchant.

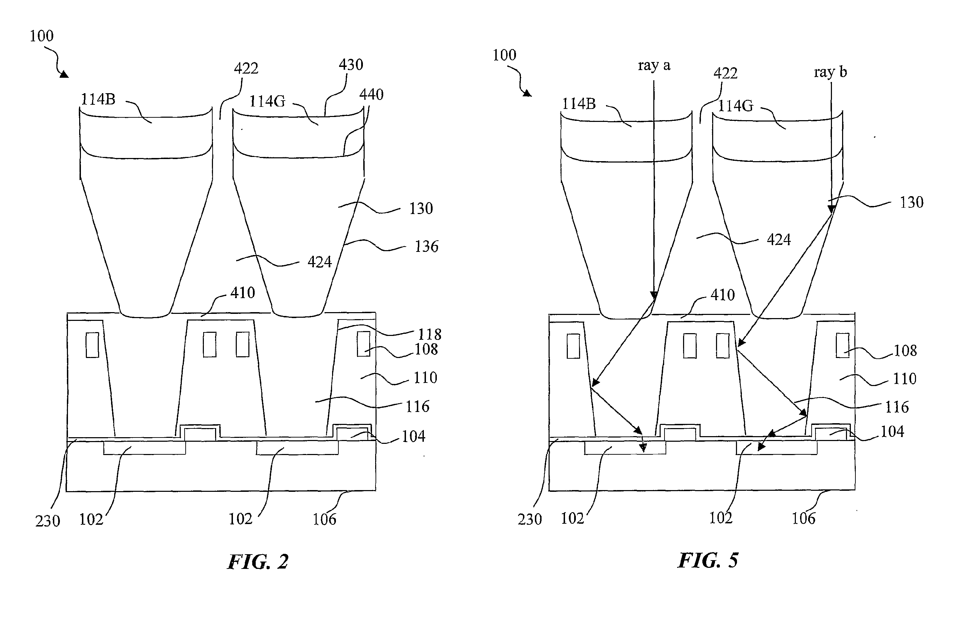

Referring to the drawings more particularly by reference numbers, Figures 2, 4A-L, 5 and 6A-B show examples of two adjacent pixels in an image sensor 100. Each pixel includes a photoelectric conversion unit 102 that converts photonic energy into electrical charges. In a conventional 4T pixel, electrode 104 may be a transfer electrode to transfer the charges to a separate sense node (not shown). Alternately, in a conventional 3T pixel, electrode 104 may be a reset electrode to reset the photoelectric conversion unit 102. The electrodes 104 and conversion units 102 are formed on a substrate 106. The sensor 100 also includes wires 108 that are embedded in an insulating layer 110.

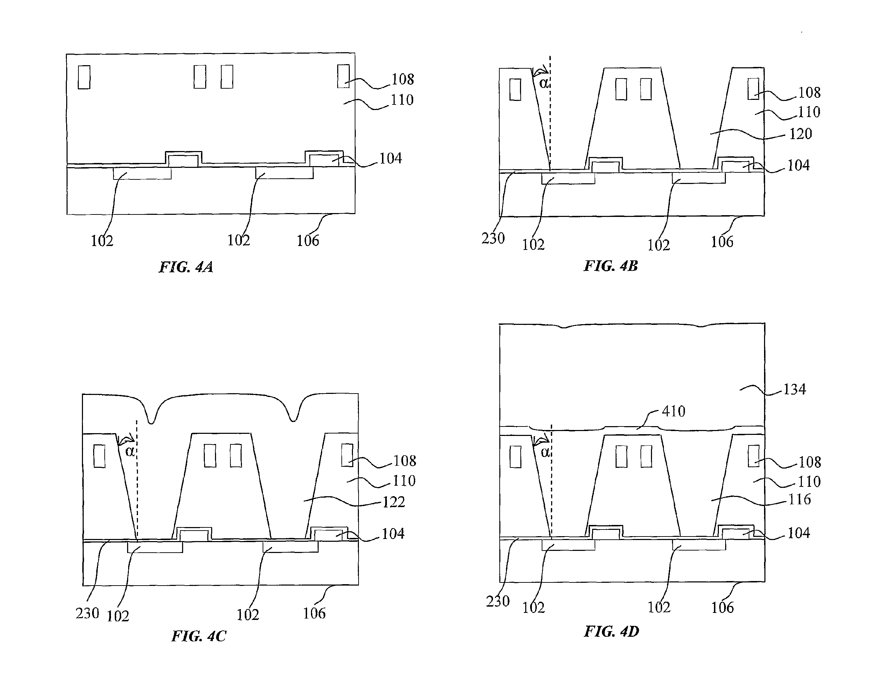

Each pixel has a first light guide 116. The first light guides 116 are constructed with a refractive material that has a higher index of refraction than the insulating layer 110. As shown in Fig. 4B, each first light guide 116 may have a sidewall 118 that slopes at an angle α relative to a vertical axis. The angle α is selected to be less than 90 - asin (n_{insulating} layer / n_{light} guide)_{,} preferably 0, so that there is total internal reflection of light within the guide, wherein n_{insulating} layer and n_{light} guide are the indices of refraction for the insulating layer material and light guide material, respectively. The light guides 116 internally reflect light from the second light guide 130 to the conversion units 102.

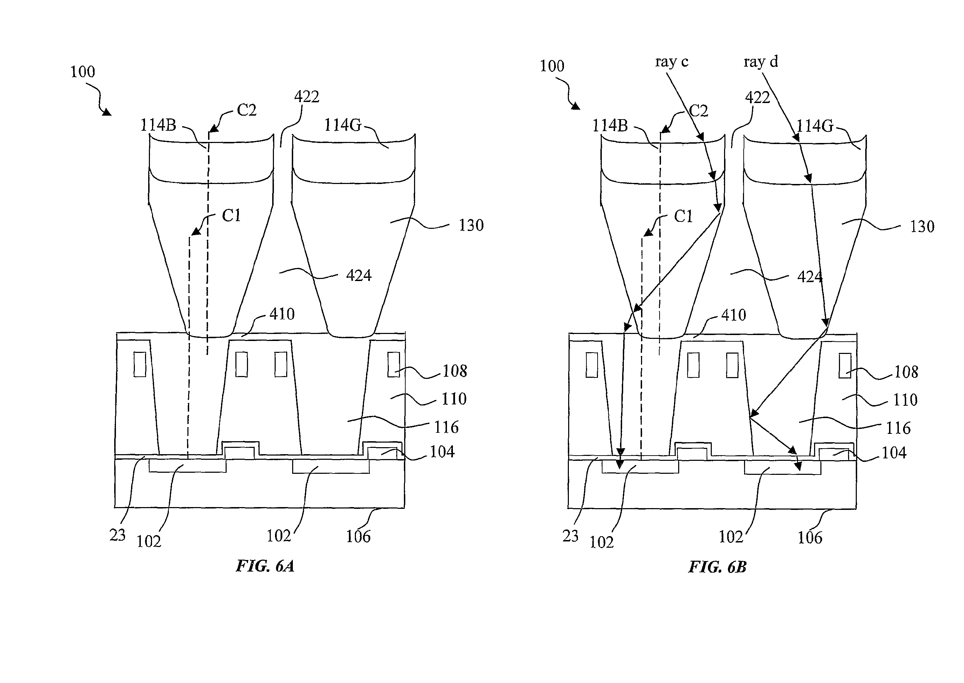

The second light guides 130 are located above first light guides 116 and may be made from the same material as the first light guide 116. The top end of the second light guide 130 is wider than the bottom end, where the second light guide 130 meets the first light guide 116. Thus the gap between adjacent second light guides 130 at the bottom (henceforth "second gap") is larger than at the top, as well as larger than the air gap 422 between the color filters 114B, 114G above the second light guides 130. The second light guides 130 may be offset laterally with respect to the first light guides 116 and/or the conversion unit 102, as shown in Figure 6A, wherein the centerline C2 of the second light guide 130 is offset from the centerline C1 of the first light guide 116 or of the photoelectric conversion unit 102. The offset may vary depending upon the pixel position within an array. For example, the offset may be greater for pixels located at the outer portion of the array. The offset may be in the same lateral direction as the incident light to optimize reception of light by the first light guide. For incident light arriving at a nonzero angle relative to the vertical axis, offset second light guides 130 pass on more light to the first light guides 116. Effectively second light guide 130 and first light guide 116 together constitute a light guide that takes different vertical cross-section shapes at different pixels. The shape is optimized to the incident light ray angle at each pixel.

Figs. 5 and 6B illustrate ray tracing for a pixel at the center of an array and at a corner of the array, respectively. In Fig. 5, incident light rays come in vertically. The second light guides 130 are centered to the first light guides 116. Both light rays a and b reflect once within the second light guide 130 then enter the first light guide 116, reflects once (ray a) or twice (ray b) and then enter conversion units 102. In Fig. 6B, the second light guides 130 are offset to the right, away from the center of the array, which is towards the left. Light ray c, which comes in from the left at an angle up to 25 degrees relative to the vertical axis, reflects off the right sidewall of the second light guide 130, hits and penetrates the lower-left sidewall of the same, enters the first light guide 116, and finally reaches conversion unit 102. The offset is such that the first light guide 116 recaptures the light ray that exits lower-left sidewall of second light guide 130. At each crossing of light guide sidewall, whether exiting the second light guide or entering the first light guide, light ray c refracts in a way that the refracted ray's angle to the vertical axis becomes less each time, enhancing propagation towards the photoelectric conversion unit. Thus, having a light guide built from a first light guide 116 and a second light guide 130 allows the vertical cross-section shape of the light guide to vary from pixel to pixel to optimize for passing light to the photoelectric conversion unit 102.

Building a light guide from two separate light guides 116, 130 has a second advantage of reducing the etch depth for each light guide 116, 130. Consequently, side wall slope angle control can achieve higher accuracies. It also makes deposition of lightguide material less likely to create unwanted keyholes, which often happen when depositing thin film into deep cavities, causing light to scatter from the light guide upon encountering the keyholes.

Color filters 114B, 114G are located above the second light guides 130. The sidewall upper portion at and adjacent to the color filters is more vertical than the rest of second lightguide.

First air-gap 422 between the color filters has a width of 0.45um or less, and a depth of 0.6um or greater. An air gap with the dimensional limitations cited above causes the light within the gap to be diverted into the color filters and eventually to the sensors. Thus the percentage loss of light impinging on the pixel due to passing through the gap (henceforth "pixel loss") is substantially reduced.

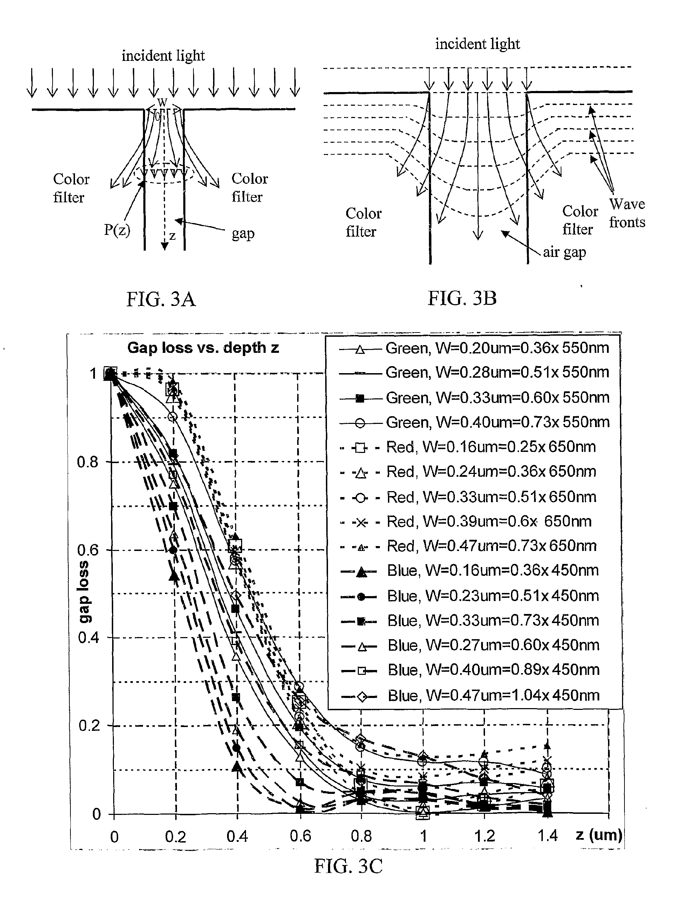

Light incident upon a gap between two translucent regions of higher refractive indices become diverted to one or the other when the gap is sufficiently narrow. In particular, light incident upon an air gap between two color filters diverts to one color filter or the other when the gap width is sufficiently small. Figure 3A shows a vertical gap between two color filter regions filled with a lower refractive index medium, e.g. air. Incident light rays entering the gap and nearer one sidewall than the other is diverted towards and into the former, whereas the rest are diverted towards and into the latter. Figure 3B shows wavefronts spaced one wavelength apart. Wavefronts travel at slower speed in higher refractive index medium, in this example the color filter having an index n of approximately 1.6. Thus the spacing between wavefronts in the gap, assuming air filled, is 1.6 times that of the color filter, resulting in the bending of wavefronts at the interface between the color filter and air gap and causing the light rays to divert into the color filter. Figure 3C is a graph of propagated light power P(z) along a vertical axis z of the air gap divided by the incident light power P(0) versus a distance z. As shown by Fig. 3C, light power decreases deeper into the gap for different gap widths, more rapidly for lesser gap widths on the order of one wavelength and converges to be essentially negligible for a gap width of 0.4 times wavelength or less at a depth of 1.5 times wavelength. From Fig. 3C, it is preferable to have a depth equal to at least 1 times the wavelength of the longest wavelength of interest, which is 650nm in this example for a visible light image sensor. At this depth, the percentage of light power incident upon the gap and lost to the space further below (henceforth "gap loss") is less than 15%. The color filter thus needs to have thickness at least 1 time the wavelength in order to filter incident light entering the gap to prevent unfiltered light from passing on to light guides 130, 114 and eventually to the conversion unit 102. If the gap is filled with a transparent medium other than air, with refractive index n_{gap} > 1.0, then presumably the gap would need to narrow to 0.45um/n_{gap} or less, since effectively distances in terms of wavelength remains the same but absolute distances are scaled by 1/n_{gap}.

Referring to Figure 3C, for red light of wavelength in air of 650nm, at a depth of 0.65um (i.e. 1.0 time wavelength in air) the gap power flux attenuates to 0.15 (15%) for a gap width of 0.6 time wavelength in air, i.e. 0.39um. Attenuation reaches maximum at around 1um of depth. Attenuation is steeper with depth for shorter wavelengths.

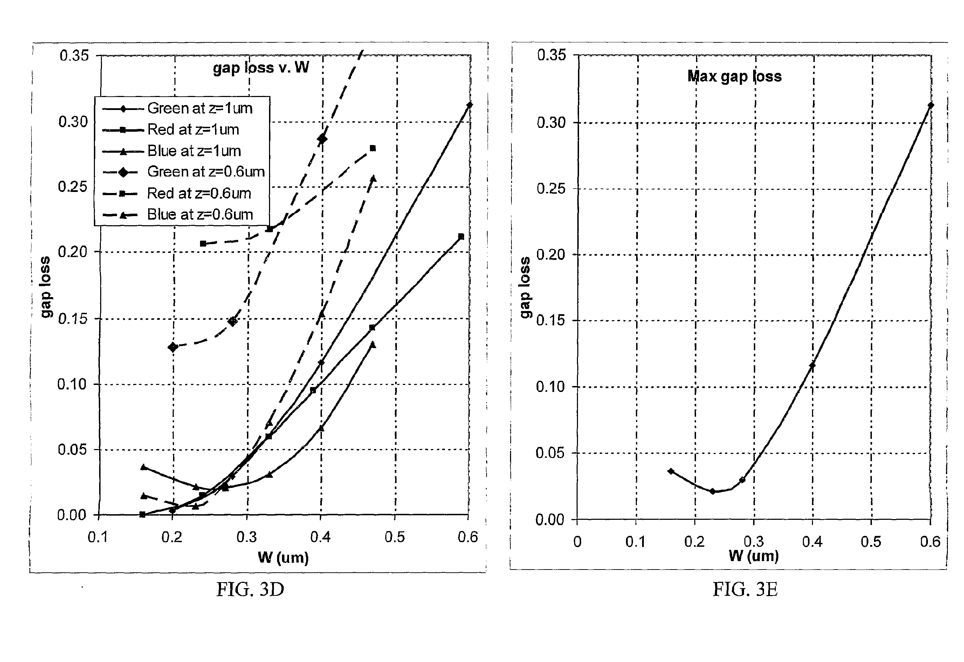

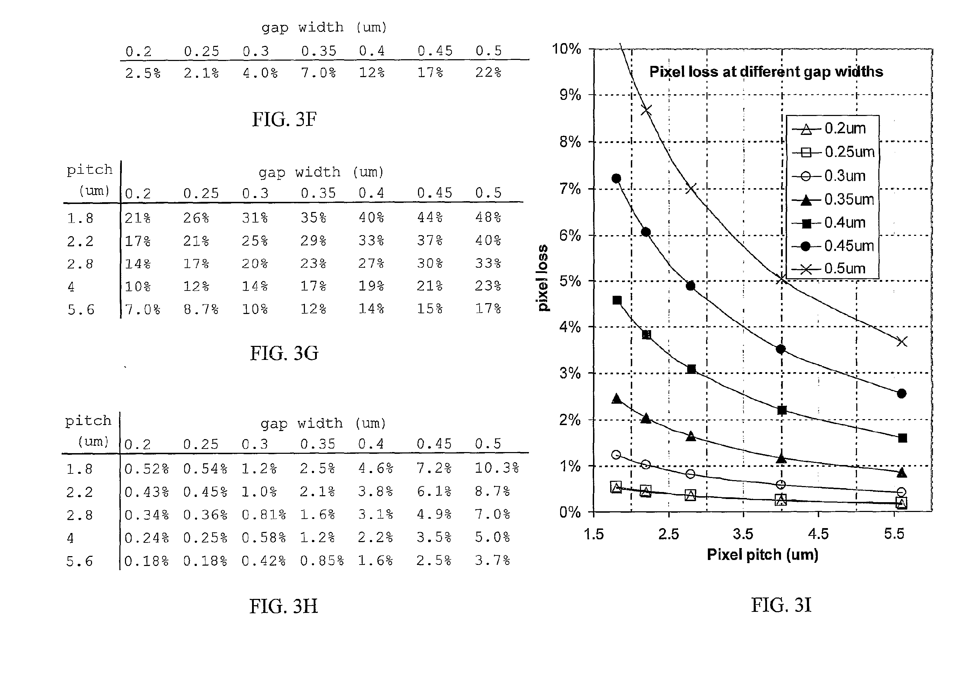

Figure 3D shows the gap loss versus gap width W for 3 colors--blue at 450nm wavelength, green at 550nm, and red at 650nm--at depths of 0.6um and 1.0um, respectively. For a depth of 1.0um, the highest gap loss among the 3 colors and the maximal gap loss for gap widths of 0.2um to 0.5um are plotted in Figure 3E. Gap loss against gap width is tabulated in Figure 3F. In Figure 3G, gap area as percentages of pixel areas is tabulated against pixel pitch and gap width. Each entry (percentage gap area) in the table of Fig. 3G is multiplied with the corresponding column entry (i.e. gap loss) to give pixel loss as tabulated in Figure 3H. Figure 3I plots pixel loss versus pixel pitch for different gap widths ranging from 0.2um to 0.5um.

Fig. 3I shows that keeping gap width below 0.45um would result in less than 8% pixel loss for pixel pitch between 1.8um and 2.8um--the range of pixel sizes for compact cameras and camera phones--for color filter thickness of 1.0um. For less than 3%, a gap width below 0.35um is needed; for less than 1.5%, a gap width below 0.3um; and for less than 0.5%, a gap width below 0.25um. Fig. 3I also shows that pixel loss is less for bigger pixels given the same gap width. Thus for pixels larger than 5um, the above guidelines result in at least halving the pixel loss.

Referring to Figures 2 and 5 again, it is clear that the first air-gap 422 prevents crosstalk from the color filter of one pixel to an adjacent pixel by internal reflection. Thus the color filters 114B, 114G each functions like a light guide. Together, the color filter, the second light guide, and the first light guide along ray a in Figure 5 are cascaded together to capture incident light and convey to the photoelectric conversion unit 102 while minimizing loss and crosstalk. Unlike prior art which uses metal walls or light absorbing walls between color filters to reduce crosstalk, at the expense of losing light that impinging on such walls, the first air-gap 422 achieves negligible gap loss by diverting light to the nearest color filter. And since there is no underlying flattening layer below the color filters that bridges between adjacent light guides like in prior art (see Figure IB), the associated crosstalk is also eliminated.

Air interface may continue from the color filter sidewall along the second light guide sidewall and end above protection film 410, creating a second air gap 424. The air interface between second air gap 424 and the second light guide 130 enhances internal reflection for the second light guide 130.

A protection film 410 may be formed above insulating layer 110 of silicon nitride to prevent alkali metal ions from getting into the silicon. Alkali metal ions, commonly found in color filter materials, can cause instability in MOS transistors. Protection film 410 also keeps out moisture. The protection film 410 may be made of silicon nitride (Si3N4) of thickness between 10,000 Angstroms and 4,000 Angstroms, preferably 7,000 Angstroms (1 Angstrom = 0.1 nanometers) . If either first light guide 116 or second light guide 130 is made of silicon nitride, the protection film 410 which is formed of silicon nitride is continuous across and above the insulating layer 110 to seal the transistors from alkali metal ions and moisture. If both first 116 and second 130 light guides are not made of silicon nitride, the protection film 110 may cover the top surface of the first light guide 116 to provide similar sealing or, alternatively, cover the sidewalls and bottom of first light guide 116.

First 422 and second 424 air gaps together form a connected opening to air above the top surface of the image sensor. Viewing this in another way, there exists a continuous air interface from the protection film 410 to the top surfaces of the color filters 114B, 114G. In particular, there is an air-gap between the top surfaces 430 of the pixels. The existence of this opening during manufacture allows waste materials formed during the forming of first air gap 422 and second air gap 424 to be removed during the manufacture of the image sensor. If for some reason the first air-gap 422 is sealed subsequently using some plug material, this plug material should have a refractive index lower than the color filter material so that (i) there is internal reflection within the color filter, and (ii) light incident within the air-gap 422 is diverted into the color filters 114B, 114G. Likewise if some fill material fills the second air gap 424, this fill material needs to have a lower refractive index than the second light guide 130.

Together, the color filter 114 and light guides 130 and 116 constitute a "cascaded light guide" that guides light to the photoelectric conversion unit 102 by utilizing total internal reflection at the interfaces with external media such as the insulator 110 and air gaps 422 and 424. Unlike prior art constructions, light that enters the color filter does not cross over to the color filter of the next pixel but can only propagate down to the second light guide 130. This makes it unnecessary to have a microlens above to focus light to the center of the pixel area to prevent light ray passing out from a color filter of a pixel to an adjacent pixel. Doing away with microlens has a benefit of eliminating the aforementioned problem of alignment error between microlens and color filter that can cause crosstalk, in addition to lowering manufacturing costs.

As mentioned before, a cascaded light guide further holds an advantage over prior art that uses opaque wall material between color filters in that incident light falling into the first air gap 422 between color filters 114B and 114G is diverted to either one, thus no light is lost, unlike prior art pixels where light is lost to the opaque walls between the filters.

An advantage of this color filter forming method over prior art methods is that the color filter sidewall is not defined by the photoresist and dye materials constituting the color filters. In prior art color filter forming methods, the color filter formed must produce straight sidewalls after developing. This requirement places a limit on the selection of photoresist and dye material because the dye must not absorb light to which the photoresist is sensitive, otherwise the bottom of the color filter will receive less light, resulting in color filter that is narrower at its bottom than its top. The present color filter forming method forms the color filter sidewall by the pocket 210 etched into the support film 134 and not relying on the characteristics of the color filter material or the accuracy of lithography, resulting in a cheaper process.

Another advantage over prior art color filter forming methods is that gap spacing control is uniform between all pixels, and highly accurate at low cost. Here, the gap spacing is a combination of the line-width in the single lithography step that etches the openings in the support film, plus the control of sideway etching during dry etch, both easily controlled uniformed and highly accurately without adding cost. If such gaps were to be created by placing 3 color filters of different colors at 3 different lithography steps as in the prior arts, uniformity of gap widths is difficult, the lithography steps become expensive, and sidewall profile control becomes even more stringent.

A cascaded light guide wherein a color filter 114 and a light guide 130 are formed in the same opening in the support film 134 (henceforth "self-aligned cascaded light guide") has an advantage over prior art in that there is no misalignment between the color filter 114 and the light guide 130. The color filter 114 has sidewalls that self-align to sidewalls of the light guide 130.

Figures 4A-L show a process for forming an example of the image sensor useful for understanding of this invention. The image sensor may be processed to a point where the conversion units 102 and electrodes 104 are formed on the silicon substrate 106 and the wires 108 are embedded in the insulator material 110 as shown in Figure 4A. The insulator 110 may be constructed from a low refractive index ("RI") material such as silicon dioxide (RI=1.46). The top of the insulator 110 may be flattened with a chemical mechanical polishing process ("CMP").

As shown in Figure 4B, insulating material may be removed to form light guide openings 120. The openings 120 have sloping sidewalls at an angle α. The openings 120 may be formed, by example, using a reactive ion etching ("RIE") process. For silicon oxide as the insulating material, a suitable etchant is CF₄+CHF₃ in a 1:2 flow ratio, carried in Argon gas under 125mTorr, 45°C. The sidewall angle may be adjusted by adjusting the RF power between 300W and 800W at 13.56MHz.

Figure 4C shows the addition of light guide material 122. By way of example, the light guide material 122 can be a silicon nitride that has an index of refraction of 2.0, greater than the refractive index of the insulating material 110 (e.g. silicon oxide, RI=1.46). Additionally, silicon nitride provides a diffusion barrier against H₂O and alkali metal ions. The light guide material can be added for example by plasma enhanced chemical vapor deposition ("PECVD").

The light guide material may be etched down to leave a thinner and flatter protection film 410 to cover the insulator and seal the conversion unit 102, gate 104, and electrodes 108 against H₂O and alkali metal ions during the subsequent processes. Alternatively, if the first light guide material 122 is not silicon nitride, a silicon nitride film may be deposited on top of light guide material 122 after an etch-down of the latter to flatten the top surface, to form a protection film 410 that seals the conversion unit 102, gate 104, and electrodes 108 against H₂O and alkali metal ions. The protection film 410 may be between 10,000 Angstroms and 4,000 Angstroms thick, preferably 7,000 Angstroms (1 Angstrom = 0.1 nanometers) .

A shown in Figure 4D a support film 134 is formed on top of the silicon nitride. The support film 134 may be silicon oxide deposited by High Density Plasma ("HDP").

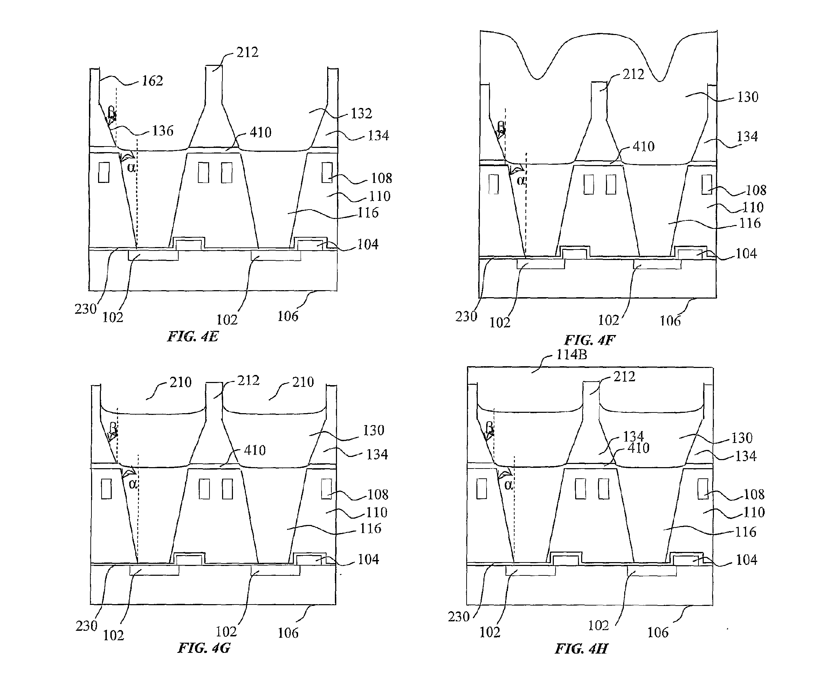

In Figure 4E, the support film is etched to form openings. The openings may include sidewalls 136 that slope at an angle β. The angle β is selected so that β< 90 - asin (1 / n2_{light guide}), where n2_{light} guide is the index of refraction of the second light guide material 130, such that there is a total internal reflection within the second light guides 130. Incorporating two separate lights guides reduces the etching depth for each light guide. Consequently, slope side wall etching is easier to achieve with higher accuracy. The support film 134 and second light guides 130 may be made from the same materials and with the same processes as the insulating layer 110 and first light guides 116, respectively.

As shown in Fig. 4E the sidewall may have a vertical portion and a sloped portion. The vertical portion and sloped portion can be achieved by changing the etching chemistry or plasma conditions during the etching process. The etch recipe during the vertical portion etch is selected to be favorable for forming the vertical sidewall 162, then switched to a recipe favorable for forming the sloped sidewall.

Figure 4F shows the addition of light guide material. By way of example, the light guide material can be a silicon nitride deposited for example by plasma enhanced chemical vapor deposition ("PECVD").

Figure 4G shows each second light guide 130 has a pocket 210. The pockets 210 are separated by a support wall 212, being part of the support film 134. Pocket 210 may be formed by etching down light guide material to expose the wall 212 and further till the top surface of light guide is below the top surface of the wall 212 by between 0.6um to 1.2um.

As shown in Fig. 4H, a color film material 114B having a particular color, for example blue or magenta or yellow, may be applied to fill the pockets 210 and extends above the support film 134. In this example, the color material may contain blue dye. Color filter material is may be made of negative photoresist, which forms polymers that when exposed to light becomes insoluble to a photoresist developer. A mask (not shown) is placed over the material 114B with openings to expose areas that are to remain while the rest is etched away.

Color filter material used may comprise inorganic particles interspersed therein that have diameters less than a small fraction, for instance a quarter, of the wavelengths of the light permitted to pass through. For instance, zirconium oxide and tantalum oxide particles of diameters less than 100nm may be mixed in the blue color filter of this example. Particles of inorganic materials that are transparent to the intended color and have high refractive index, preferably above 1.9, can increase the overall refractive index of the color filter to enhance sidewall internal reflection of the color filters used in this example.

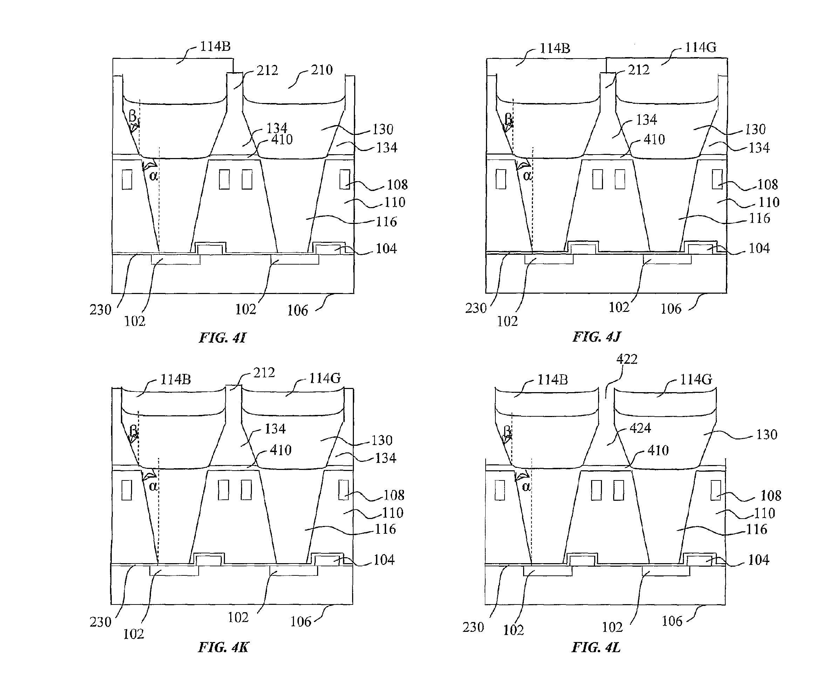

Figure 4I shows the image sensor after the etching step. The process can be repeated with a different color material such as green or red to create color filters for different pixels as shown in Figure 4J. The last color material applied fills the remaining pockets 210, thus requires no mask step. In other words, exposure light may be applied everywhere on the image sensor wafer to exposure the last color filter film everywhere. During the bake step, the last color filter forms a film that overlaps all pixels, including pixels of other colors. The overlap of the last color filter on other pixels is removed during a subsequent color filter etch-down process shown in Figure 4K.

Referring to Figure 4G, the pockets 210 provide an self-alignment feature to self-align the color filter material with the second light guide 130. The pockets 210 may be wider than the corresponding mask openings. To reduce the thickness of the support wall 212 for an desired second light guide opening for a given pixel pitch, the pressure in the plasma chamber may be increased to enhance sideway (i.e. isotropic) etch (by increasing ion scattering) to undercut the mask.

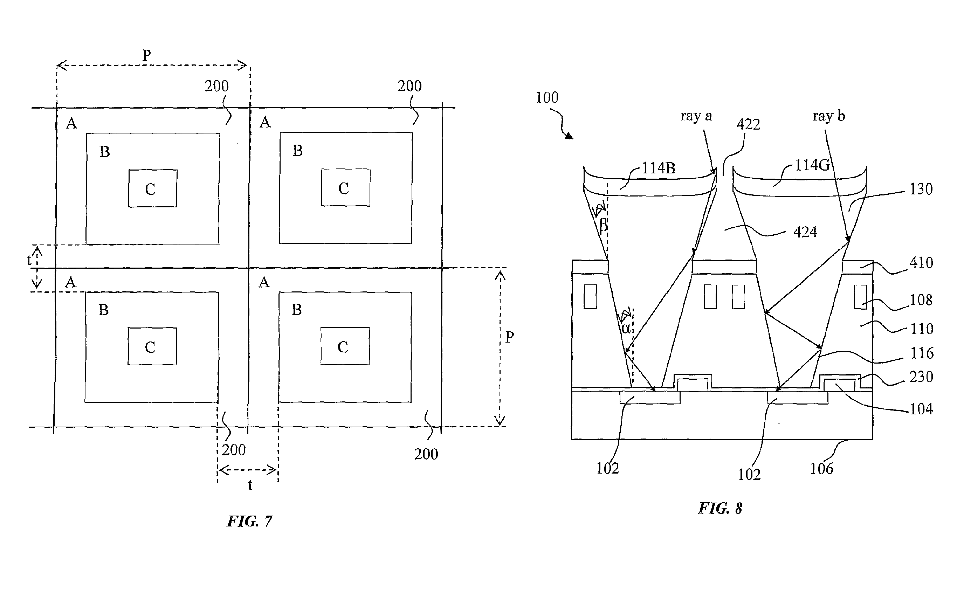

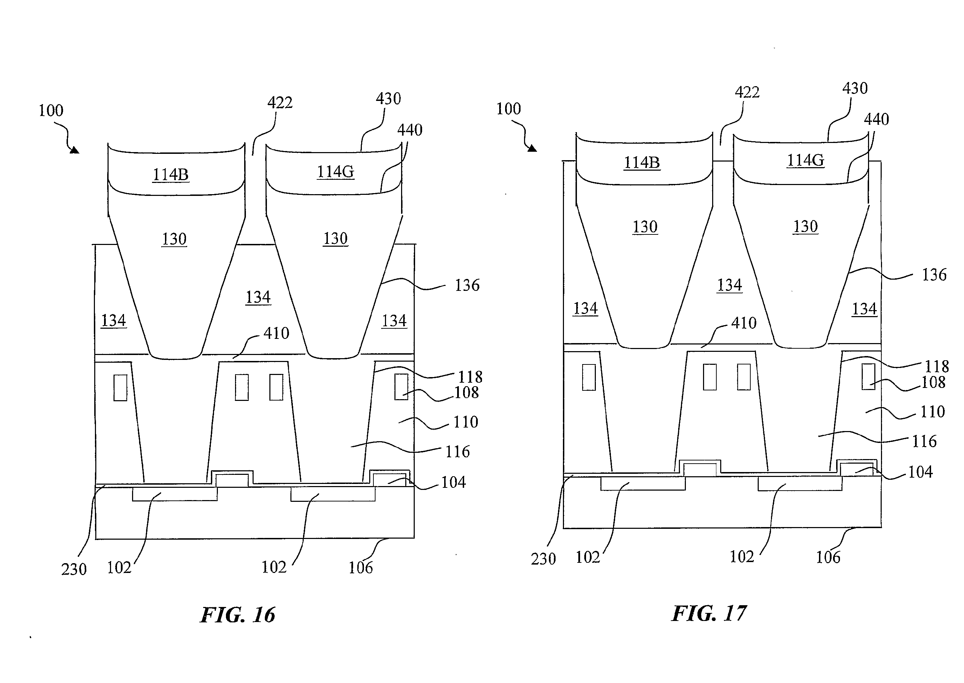

As shown in Figure 4K the color filters 114B, 114G are etched down to expose the support wall 212, being part of the support film 134. A portion of the support film 134 is then removed as shown in Figure 4L so that there is an air/material interface for the color filters 114B, 114G. A further portion of the support film 134 may be removed as shown in Figure 4L so that there is an air/material interface for the second light guide 130 to further aid internal reflection by allowing light rays closer to the perpendiculars to the interface to undergo total internal reflection. The first gap 422 has a width sufficiently small, 0.45um or less, so that incident red light and light of lesser wavelengths impinging into the first gap 422 is diverted to either color filter 114B or 114G, thus improving light reception. Light internally reflects along the color filters 114B, 114G and light guides 130 and 116. The color filters 114B, 114G have a higher refractive index than air so that the color filters 114B, 114G provides internal reflection. Likewise, the second light guide 130 may have an air interface which improves the internal reflection properties of the guide. If the support film 134 is not completely removed, as long as the support film has a lower refractive index (e.g. silicon oxide, 1.46) than the light guide material (e.g. silicon nitride, 2.0), the interface between the second light guide 130 and the support film 134 has good internal reflection. Figure 16 shows an alternate example where the support material between the adjacent second light guides 130 is only partially removed. Likewise, the interface between the first light guide 116 and the first insulator film 110 enjoys good internal reflection. Figure 7 is a top view showing four pixels 200 of a pixel array. For examples that include both first and second light guides the area B may be the area of the second light guide top surface and the area C represents the area of the first light guide bottom surface. The area A minus the area B may be the area of the first air gap 422 between color filters.

Figure 17 shows an alternate example where the support film 134 is only partially removed between adjacent color filters 114B, 114G. The gap unfilled by support film preferably has a depth of 0.6um or greater and a width of 0.45um or less. The depth may be reduced to 0.4um if the overall refractive index of the color filter material is increased above 1.5, for instance by interspersing particles made of transparent material that has a refractive index of 1.9 or above in an amount to bring the overall refractive index to 1.7~1.8 or above.

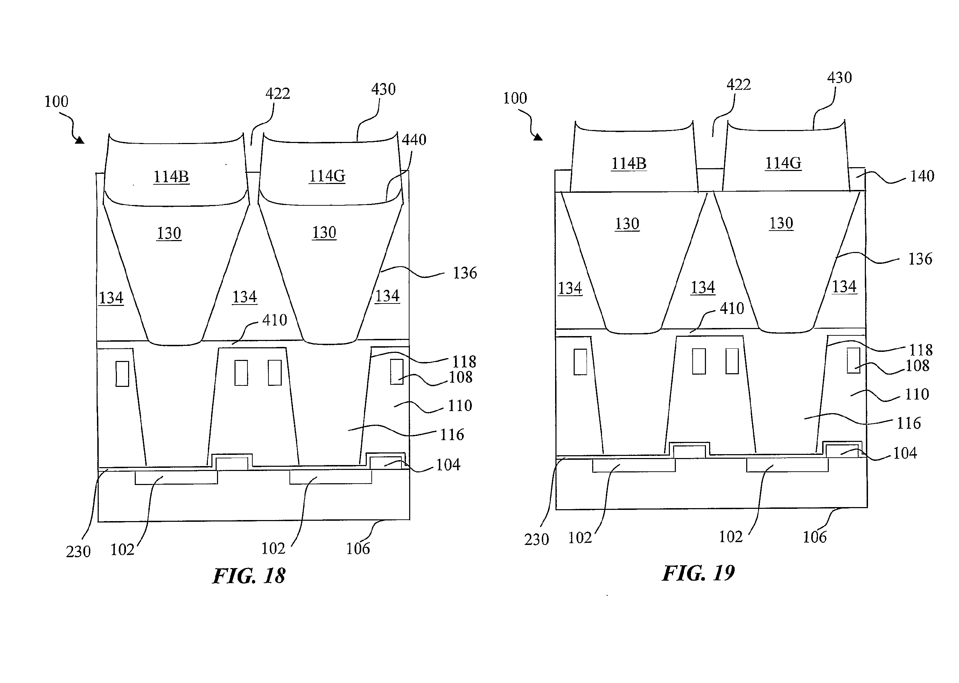

Figure 18 shows an alternate example where opposite sidewalls of each color filter are not straight and vertical. In this example, opposite sidewalls from adjacent color filters 114B, 114G sandwich a portion of the support film 134 in such a way that the support film 134 has a wider width at one depth than at a lower depth. With this property, the support film 134 exerts a downward force on each of the color filters 114B, 114G to hold the color filters in place, thus improving color filter retention. In particular, in this example, the support film 134 is wider at its top surface than at the deepest depth where it abuts the adjacent color filters 114B, 114G due to the color filters each taking a trapezoidal shape from the top of the support film 134 downwards.

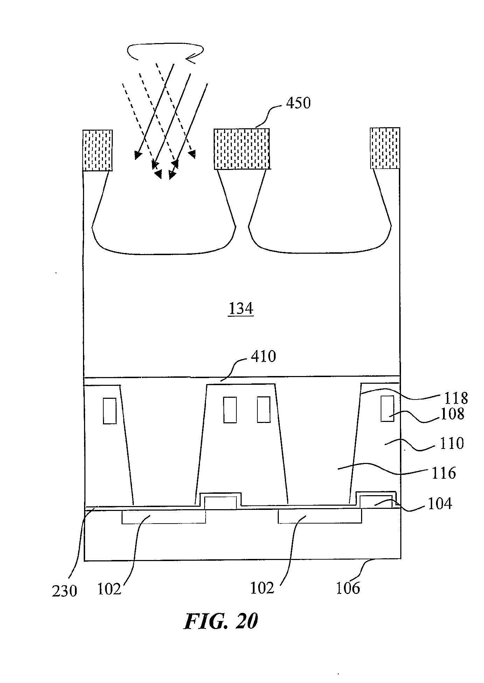

Figure 20 shows an alternate processing step to a beginning portion of the processing step shown in Figure 4E. Unlike in Figure 4E where the pit etched into the support film 134 has a top portion having vertical sidewalls, Figure 20 shows a processing step to initially open the pit such that it has a wider bottom than an opening at the top. This may be achieved by opening the pit top by anisotropic plasma etching while rotating the wafer and holding the wafer at a tilt such that a normal to the wafer makes an angle to the direction of the incoming ions in the plasma. As shown in Figure 20, relative to the wafer, the incoming ions (in solid arrows and dotted arrows) etch into the support film under the photoresist mask 450, creating sidewalls that are further apart deeper into the pit. As seen in Figure 20, a portion of the support film between adjacent pits exhibits a necking. After a pit top having this property is created, further processing may resume the remaining portion of the step description in Figure 4E, including switching to the corresponding plasma conditions, to create the remaining, lower portion of the pit for the second light guide. In particular, sidewalls 136 of the second light guide is formed below a necking of the support film 134.

Figure 19 shows an alternate example where color filters are formed in trenches formed separately from pits that house light guides. Color filters 114B, 114G, like in the alternate example in Figure 18, have sidewalls that are not vertical and straight. Between sidewalls of adjacent color filters are second support film 140 and air gap 422. Color filters 114B, 114G are each above a second light guide 130. Each filter may have a bottom that is narrower than the top of second light guide 130 by between 0.05um to 0.2um so that under worst case alignment errors each filter bottom is within the top of the corresponding light guide below.

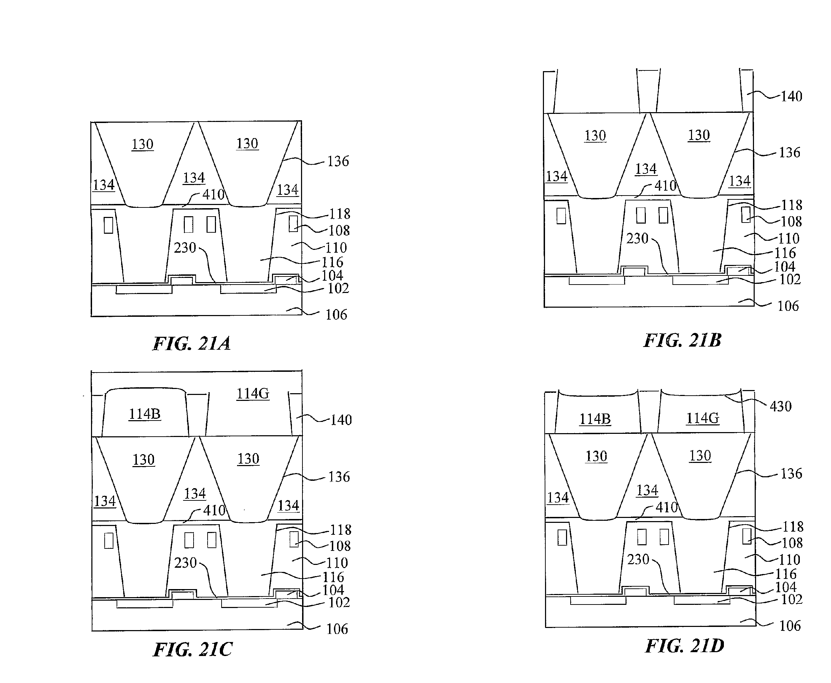

Figures 21A-21D illustrate processing steps to form the alternate example of Figure 19. The process is similar to Figures 4A-4G, except there being no provision for a portion of the pit to house a color filter. After second light guide film above the support film 134 is removed, either by etch-down or by CMP, the second light guide 130 and the support film 134 may assume the shape shown in Figure 21A. It is, however, not necessary for both to share a flush flat top, as the top surface of second light guide 130 may be lower or higher than the top of support film 134. In the latter, adjacent second light guides may be mutually connected by a thin layer of second light guide film left over from the etch-down or CMP. Subsequently, second support film 140 is deposited. Second support film 140 may be silicon oxide or any material that may be removed by a wet etch or plasma etch that has a 4X or more slower etch on color filter material to be used to form the color filters 114B, 114G. A lithography step (not shown) forms a photoresist mask (not shown) on the second support film 140, trenches are etched into the film 140 to result in the structure shown in Figure 21B. Subsequently, color filters 114B, 114G are formed in steps similar to described for Figures 4H-4K, resulting into a structure shown in Figure 21C then a subsequent one shown in Figure 21D. Finally, an etch-down of second support film 140 creates a gap 422 between adjacent color filters 114B, 114G like shown in Figure 19, in steps similar to described for Figure 4L.

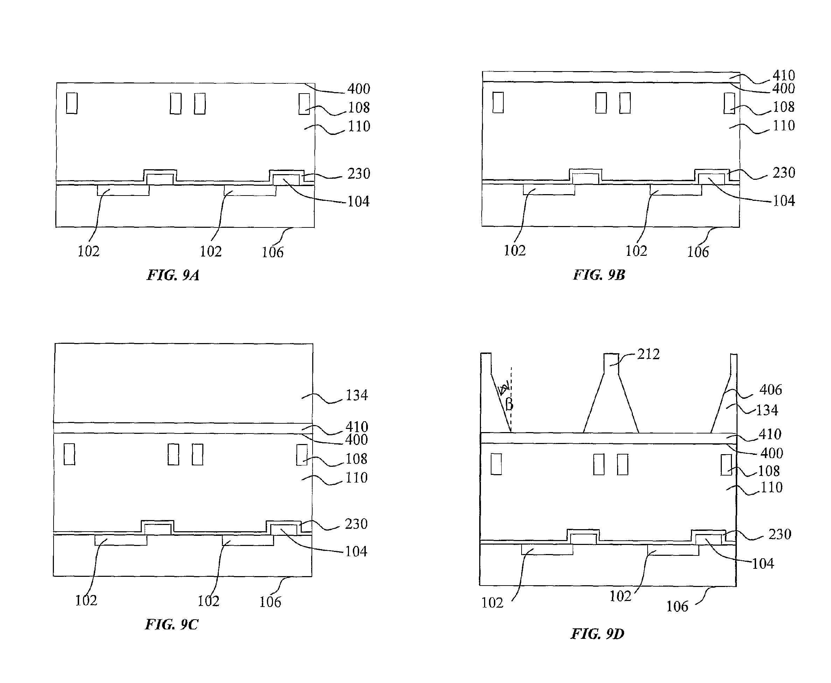

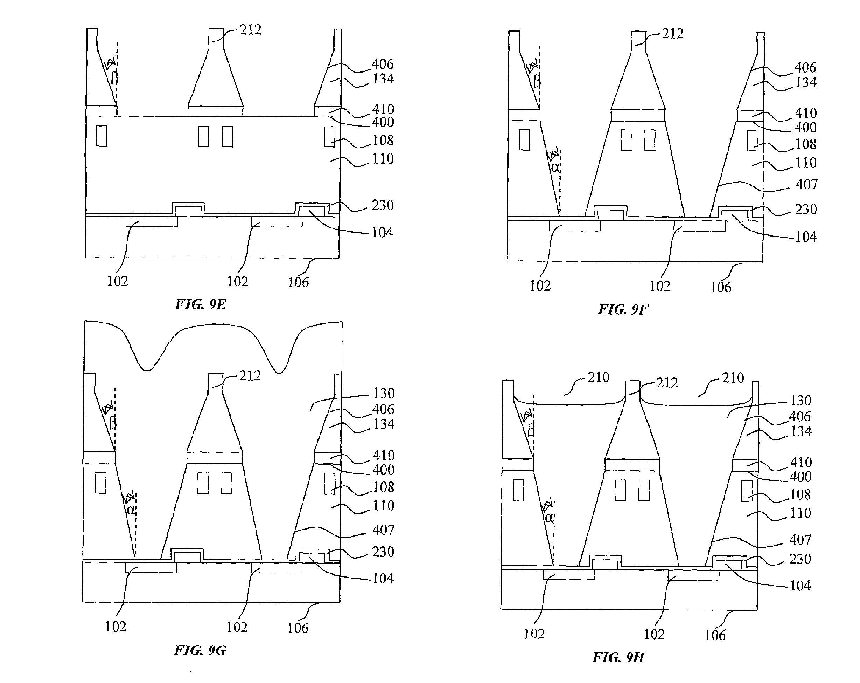

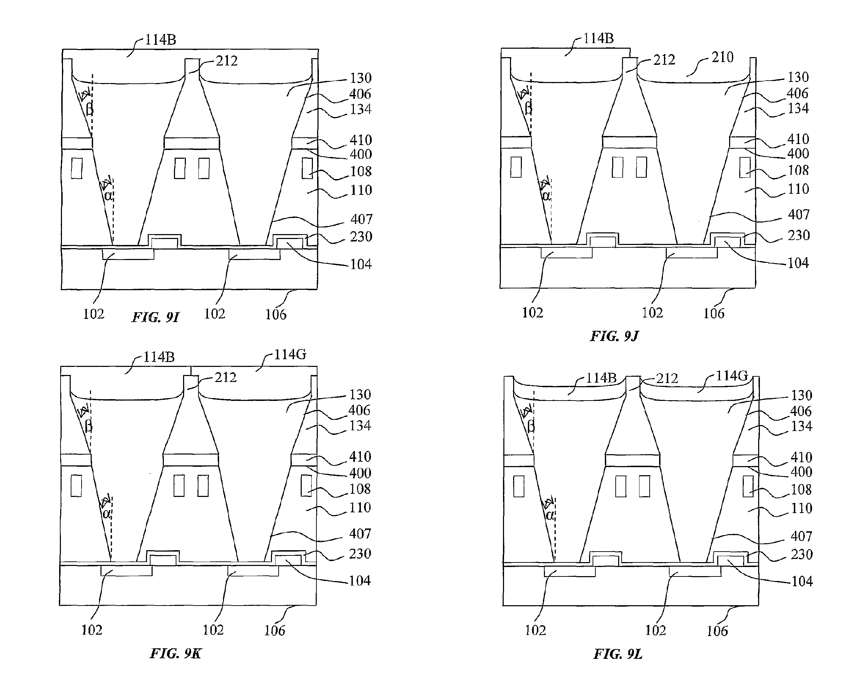

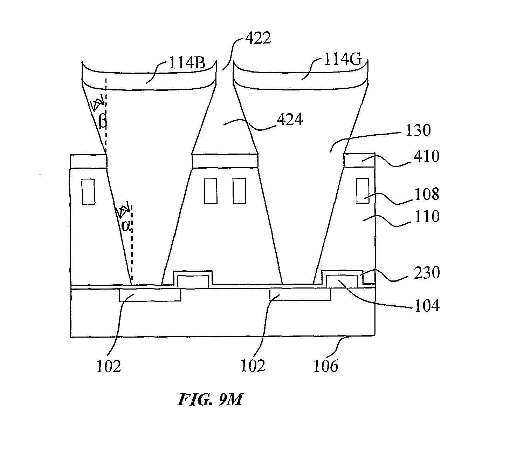

Figure 8 shows an alternate example where the second and first light guides are both etched using the same mask after the support film 134 is formed, and both filled with light guide material in one step. A process for fabricating this alternate example is shown in Figures 9A-M. The process is similar to the process shown in Figs. 4A-L, except the opening for the first light guide is formed after the opening for the second light as shown in Fig. 9F, where no additional mask is needed because the protective film 410 and the support film 134 above act as hard masks to block etchants. Both light guides are filled in the same step shown in Fig. 9G.

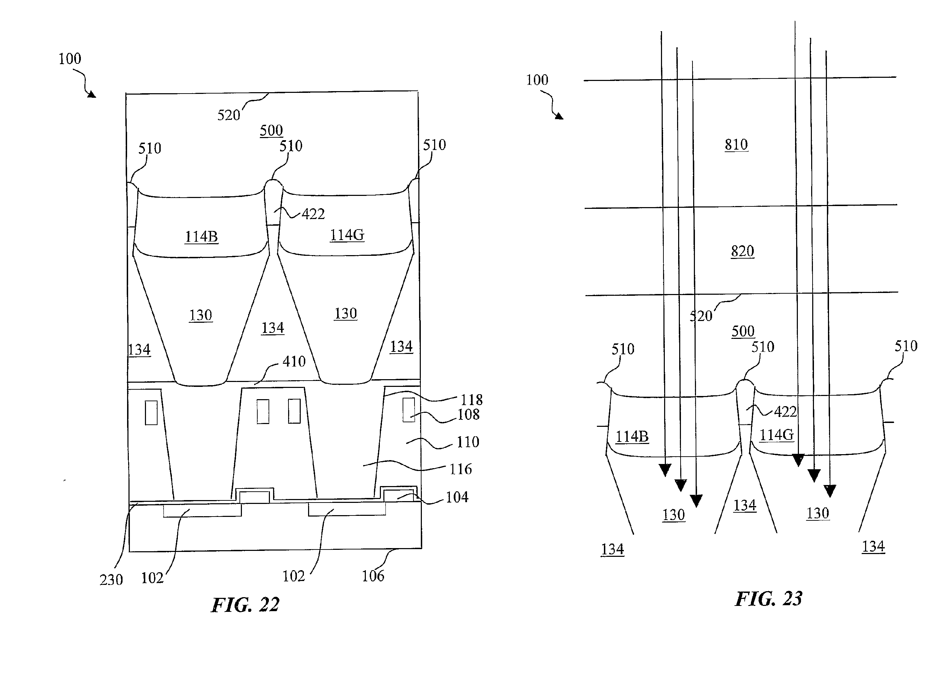

Figure 22 shows an embodiment comprising a sealing film 500 above the light guides 130 and color filters 114B, 114G that seals air-gap 422. Air gap 422 in this embodiment can hold air, nitrogen or other inert gases, or any gaseous medium. Sealing film 500 may comprise polycarbonate or acrylic or epoxy and may comprise a plurality of layers. It may further comprise inorganic particles, dye, or organic pigment for filtering ultra-violate light and/or infra-red light. Sealing film 500 may have a refractive index that is within 0.2 of the refractive index of the color filter material of color filter 114B, 114G to minimize reflection at the interface between color filter and sealing film. If the refractive index of the color filters is 1.55, the sealing film 500 may be chosen to have refractive index between 1.45 and 1.65. Sealing film 500 may be applied by dynamic spin coating where the wafer spins facing up at approximately 500 rpm while a stream of resin is dispensed at the center of the wafer through a dispensing tip and after the resin fluid completely wets the wafer top surface the wafer spins to higher speed, e.g. 3000 rpm to obtain a uniform resin thickness. The resin may be cured by heat or UV light. Air (or gas) is sealed in gap 422 during the dispensing. Heating or UV shots may be applied during either one or both of dispensing and high-speed spin to promote viscosity to prevent resin fluid from filling the gaps. Final heating or UV cure hardens the sealing film 500, and may help form boundary 510 into a concave shape due to thermal expansion of air/gas in the gap 422. The concave film surface 510 helps to diverge light rays that enter into the bubble from the sealing film 500 and direct the rays towards either color filter 114G or 114B. As a result, the depth for air gap 422 may be halved compared with example having no sealing film 500. The wafer may be faced downwards during high-speed spin. Portions of the sealing film 500 above bond pads may be removed by any one of the known methods.

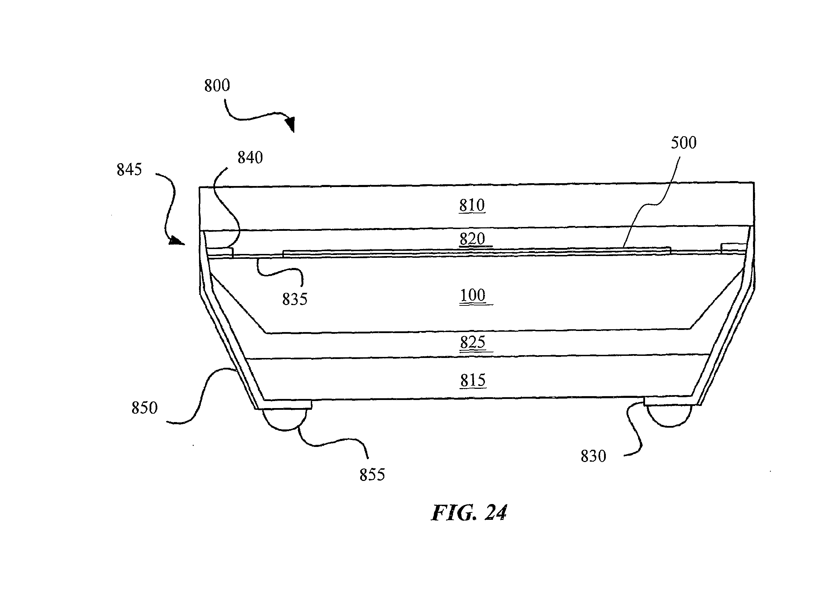

Figure 24 shows the image sensor 100 packaged in a package 800. A cover glass 810 is above the image sensor 100 to keep out dust and let light in. Between cover glass 810 and image sensor 100, a transparent adhesive film 820 such as epoxy resin fills the space and is cured by heat or UV light. Together, the sealing film 500 and the adhesive film 820 constitute a transparent film filling the space between the cover glass 810 and the color filters of the image sensor 100. If the sealing film 500 and the adhesive film 820 comprise the same material(s), during this curing, the adhesive film 820 and the sealing film 500 can merge together into one homogeneous transparent film.

The example shown in Figure 24 is a known wafer-level chip-scale package known under the trade name ShellOp from ShellCase, now Tessera. This package is sealed from below by lower glass plate 815, held to the image sensor 100 by epoxy 825. Inverted external leads 830 are electrically connected to die terminals 835 by trace contacts 840 at junctions 845. Junction 845 is sometimes referred to as a T-junction, and contact 840 as a T-junction contact. External leads 830 are coated with a protective solder-mask 850. Solder-mask 850 is a dielectric material that electrically isolates leads 830 from external contact, and protects the lead surface against corrosion. Contacts 855 are attached to the bottom end of leads 830, and are suitable for printed circuit board (PCB) mounting by known methods. Contacts 855 may be formed by known methods such as solder-balls or plating, and may be suitably shaped for PCB mounted.

As shown in Figure 23, from above the cover glass 810, incoming light rays pass through only flat interfaces to enter second light guides 130. Each interface has minimal reflection due to the small difference in refraction indices on both sides, since glass has approximately 1.46, epoxy 820 and sealing film 500, and color filters 114B, 114G between 1.45 to 1.65.

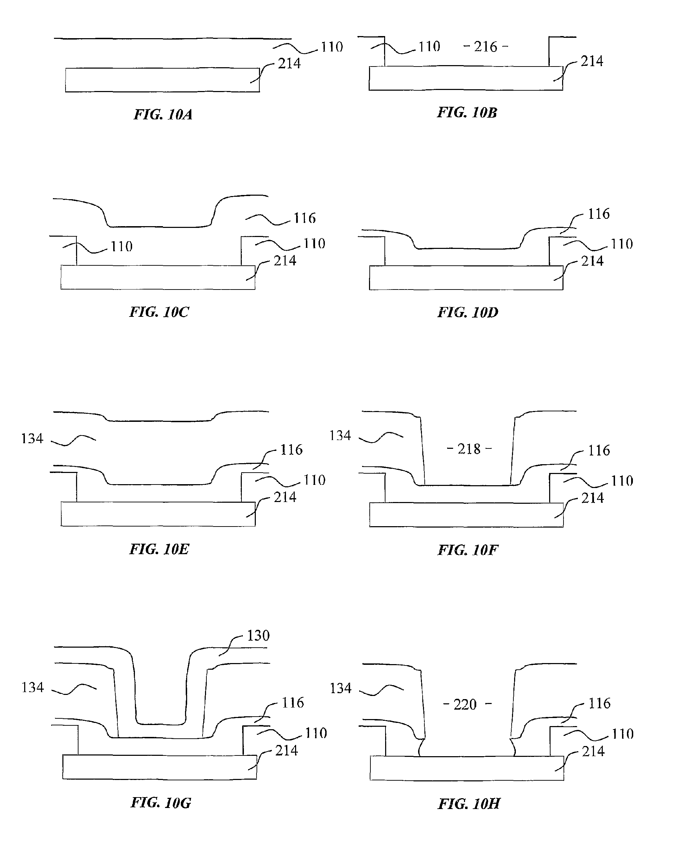

Figures 10A-H show a process to expose bond pads 214 of the image sensor. An opening 216 may be formed in a first insulator material 110 that covers a bond pad 214 as shown in Figs. 10A-B. As shown in Figs. 10C-D the first light guide material 116 is applied and a substantial portion of the material 116 may be removed, leaving a thinner layer to seal the first insulator material 110 below. The support film material 134 may be applied and a corresponding opening 218 formed therein as shown in Figs. 10E-F. The second light guide material 130 may be applied as shown in Fig. 10G. As shown in Fig. 10H a maskless etch step may be used to form an opening 220 that exposes the bond pad 214. The etchant preferably has a characteristic that attacks light guide material 116 and 130 (e.g. silicon nitride) faster than the insulator material 110 and 134 (e.g. silicon oxide) and color filter 114 (photoresist). Dry etch in CH₃F/O₂ has 5x~10x greater etch rate on silicon nitride than on color filter or silicon oxide.

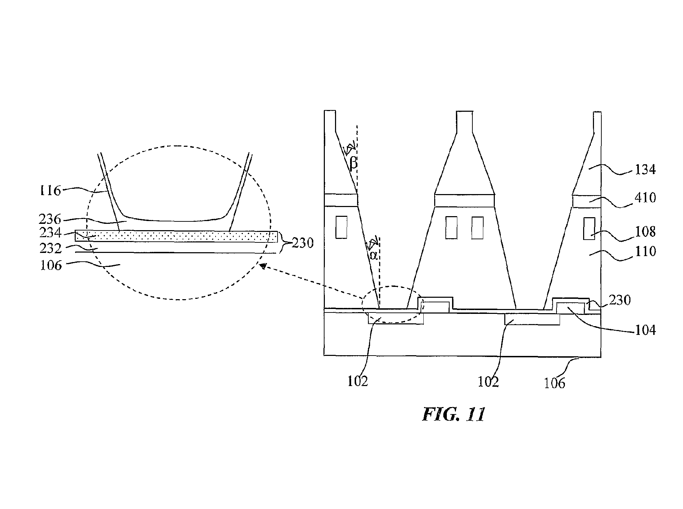

Figure 11 shows an example where an anti-reflection (AR) stack comprising a top AR film 236, a second AR film 234, and a third AR film 236 covers the conversion units 102. The anti-reflection stack improves the transmission of light from the first light guide 116 to the conversion units 102. Members of the AR stack together may constitute layer 230 that also blanket the substrate 106, conversion units 102 and electrodes 104 to protect the elements from chemical pollutants and moisture. For example, the second AR film 234 may be a contact etch-stop nitride film common in CMOS wafer fabrication for stopping the oxide etching of contact holes to prevent over-etch of polysilicon contacts whose contact holes are shallower than source/drain contacts by typically 2,000 Angstroms (1 Angstrom = 0.1 nanometers).

The third AR film 232 may be silicon oxide. This silicon oxide film may be a gate insulating film under the gate electrode 114, or the spacer liner oxide film that runs down the side of the gate electrode 114 between the gate and the spacer (not shown) in common deep submicron CMOS processes, a silicide-blocking oxide film deposited before contact silicidation to block contact siliciding, or a combination thereof, or a blanket oxide film deposited after salicide-block oxide etch that etches away all oxide in areas coinciding with the bottom of light guides 116. Using an existing silicon nitride contact etch-stop film as part of the AR stack provides cost savings. The same contact etch-stop film also functions to stop the etch of the opening in insulator 110 for fabrication of the light guide. Finally, the top AR film 236 may be formed in the opening in the insulator 110 prior to filling the opening with light guide material.

The top AR film 236 has a lower refractive index than the light guide 116. The second AR film 234 has a higher refractive index than the top AR film 236. The third AR film 232 has a lower refractive index than the second AR film 234.

The top AR film 236 may be silicon oxide or silicon oxynitride, having refractive index about 1.46, with a thickness between 750 Angstrom and 2000 Angstrom, preferably 800 Angstrom. The second AR film 234 may be silicon nitride (Si₃N₄), having refractive index about 2.0, with a thickness between 300 Angstroms and 900 Angstroms preferably 500 Angstroms (1 Angstrom = 0.1 nanometers) . The third AR film 232 may be silicon oxide or silicon oxynitride (SiOxNy, where 0<x<2 and 0<y<4/3), having refractive index about 1.46, with a thickness between 25 Angstroms and 170 Angstroms preferably 75 Angstroms (1 Angstrom = 0.1 nanometers). The third AR film 232 may comprise the gate oxide under the gate 104 and above the substrate 106 of Figure 2, as shown in Figure 3 of United States Application 61/009,454. The third AR film 232 may further comprise gate liner oxide as shown in Figure 3 of the same. Alternately, the third AR film 232 may be formed by a blanket silicon oxide deposition everywhere on the wafer after a salicide-block etch removes salicide-block oxide 64, gate-liner oxide 55, and gate-oxide 54 shown in Figure 2 of United States Application 61/009,454 by using a salicide-block-etch mask having a mask opening coinciding with the bottom of light guide 116.

The anti-reflection structure shown in Fig. 11 can be fabricated by first forming the third AR film 232 and the second AR film 234 over the substrate, respectively. The insulator 110 may be then formed on the second AR film 234. Silicon nitride film may be deposited by PECVD on the first insulator 110 in a manner that covers and seals the insulator and underlying layers to form a protection film 410 with a thickness between 10,000 Angstroms and 4, 000 Angstroms, preferably 7,000 Angstroms, The support film 134 may be formed on the protection film 410 by, for example, HDP silicon oxide deposition.

The support film 134 is masked and a first etchant is applied to etch openings in the support film 134. The first etchant may be chosen to have high selectivity towards the protection film material. For example, if the support film 134 comprises HDP silicon oxide and the protection film 410 comprises silicon nitride, the first etchant may be CHF₃, which etches HDP silicon oxide 5 times as fast as silicon nitride. A second etchant is then applied to etch through the silicon nitride protection film 410. The second etchant may be CH₃F/O₂. The first etchant is then applied again to etch the first insulator 110 and to stop on the contact etch-stop film 234 which comprises silicon nitride. The contact etch-stop film 234 acts as an etchant stop to define the bottom of the opening. The top AR film 236 is then formed in the opening by anisotropic deposition methods, for example, PECVD or HDP silicon oxide deposition, that deposits predominantly to the bottom of the opening than to the sidewalls. An etchant can be applied to etch away any residual top AR film material that extends along the sidewalls of the opening, for example by dry etch using the first etchant and holding the wafer substrate at a tilt angle and rotated about the axis parallel to the incoming ion beam. Light guide material is then formed in the openings, for example by silicon nitride PECVD. Color filters may be formed over the light guide and a portion of the support film between adjacent color filters and a further portion between adjacent light guides may be etched to create the structure shown in FIG. 5.

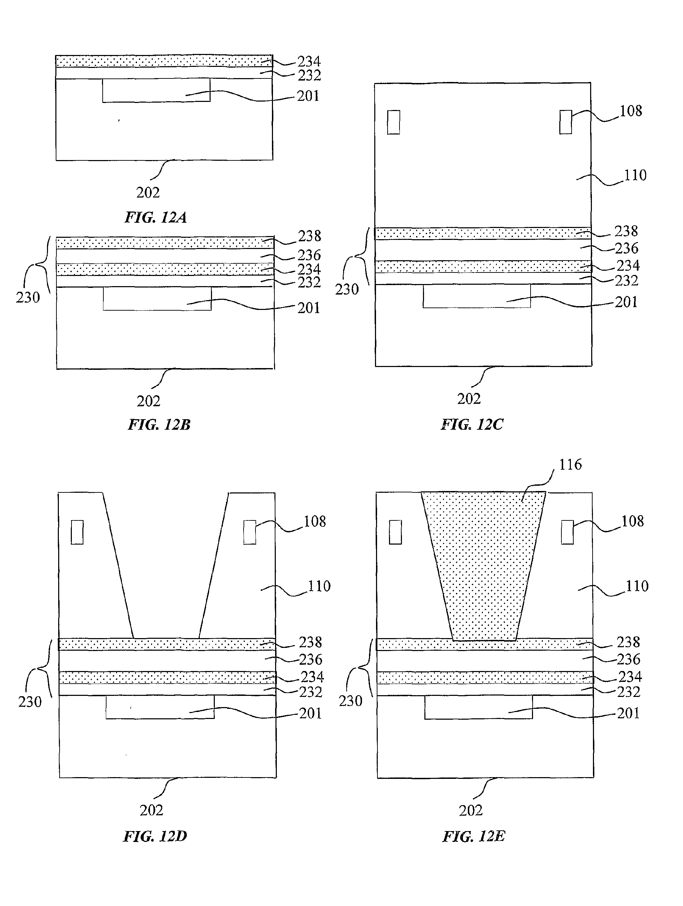

Figures 12A-E show a process for fabricating another example of anti-reflection between the light guide 116 and substrate 202. Referring to Figure 12E, in this example an etch-stop film 238 is interposed between the light guide 116 and the anti-reflection (AR) stack comprising the top AR film 236, second AR film 234, and third AR film 232. The light guide etch-stop film 238 may be formed of the same material as the light guide 116, and may be silicon nitride, with a thickness between 100 Angstroms and 300 Angstrom, preferably 150 Angstroms (1 Angstrom = 0.1 nanometers). Forming the AR stack in this example has an advantage of more precise control of the thickness of the second AR film, at the expense of one more deposition step and the slight added complexity of etching through a oxide-nitride-oxide-nitride-oxide stack instead of oxide-nitride-oxide stack for contact hole openings (not shown). The previous example uses the second AR film 234 as a light guide etch stop and loses some of thickness to the final step of insulator pit etch over-etch.

As shown in Figs. 12A-B, the third 232 and second 234 AR films are applied on the substrate 106 and then a top AR film 236 is applied onto the second AR film 234, followed by a light guide etch-stop film 238 made of silicon nitride. As shown in Fig. 12C, the insulator layer 110 and wiring electrodes 108 are formed above the AR films 232, 234, and 236, and light guide etch-stop film 238. Fig. 12D shows an opening etched into insulator 110, stopping at the top of the light guide etch-stop film 238. Fig. 12E shows the opening filled with light guide material.

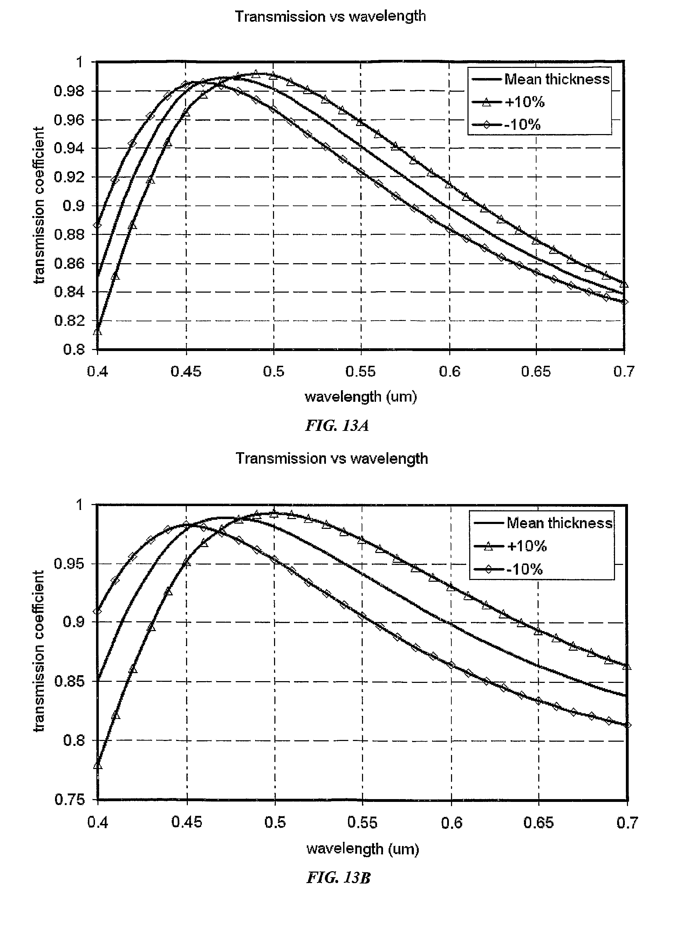

Figure 13A is a graph of transmission coefficient versus light wavelength for the anti-reflection stack of Figure 11 and Figure 12E, for top AR film 236 (oxide) nominal thickness of 800 Angstroms, and varied +/-10%, whereas second AR film 234 (nitride) thickness is 500 Angstroms and third AR film 232 (oxide) thickness is 75 Angstroms (1 Angstrom = 0.1 nanometers).

The transmission curves exhibit steep decline in the violet color region (400nm to 450nm). The nominal thicknesses of the AR films 232, 234, and 236 constituting the AR stack are chosen to position the maximum of the transmission curve in the blue color region (450nm to 490nm) instead of green color region (490nm to 560nm) so that any shift in film thicknesses due to manufacturing tolerance would not result in transmission coefficient fall-off much more in violet than in red color region (630nm to 700nm).

Figure 13B is a graph of transmission coefficient versus light wavelength for the anti-reflection stack of Figure 11 and Figure 12E, for nominal second AR film (nitride) of 500 Angstroms thick, and varied +/-10%.

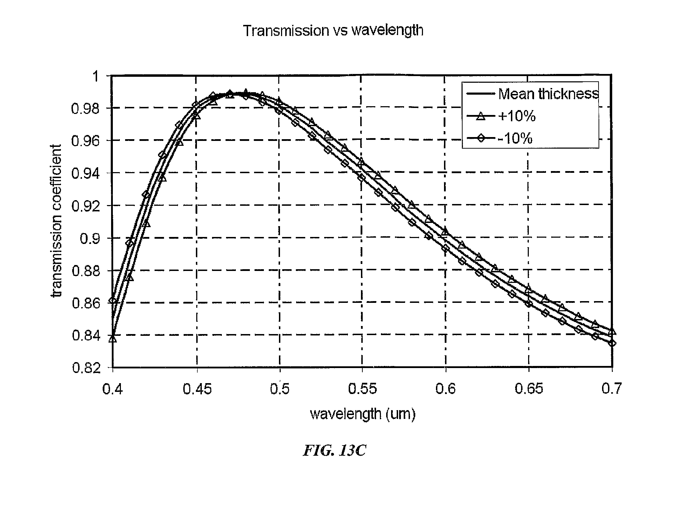

Figure 13C is a graph of transmission coefficient versus light wavelength for the anti-reflection stack of Figure 11 and Figure 12E, for third AR film 232 (nitride) nominal thickness of 75 Angstroms (1 Angstrom = 0.1 nanometers), and varied +/-10%.

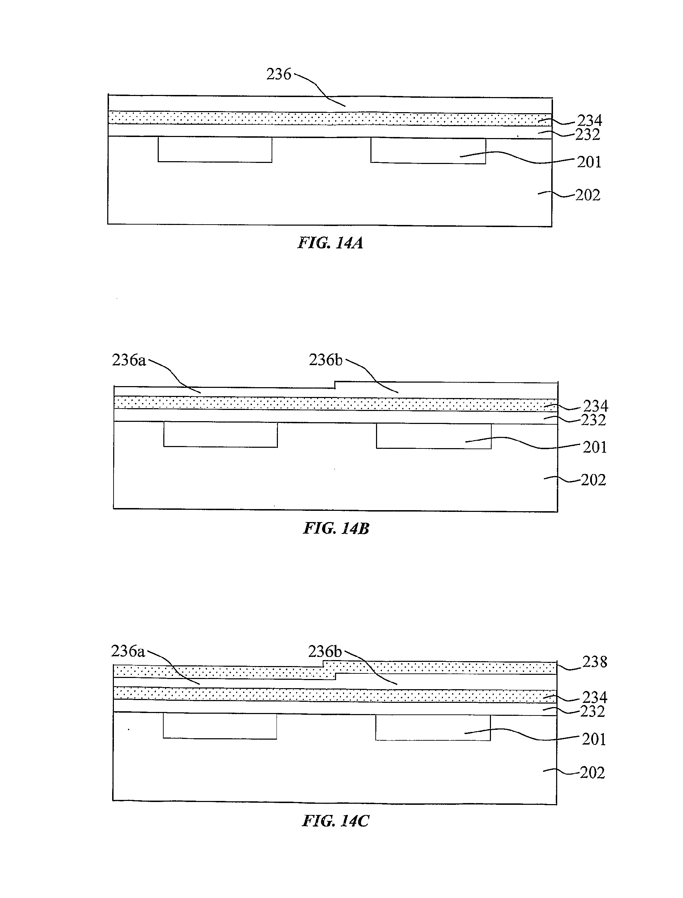

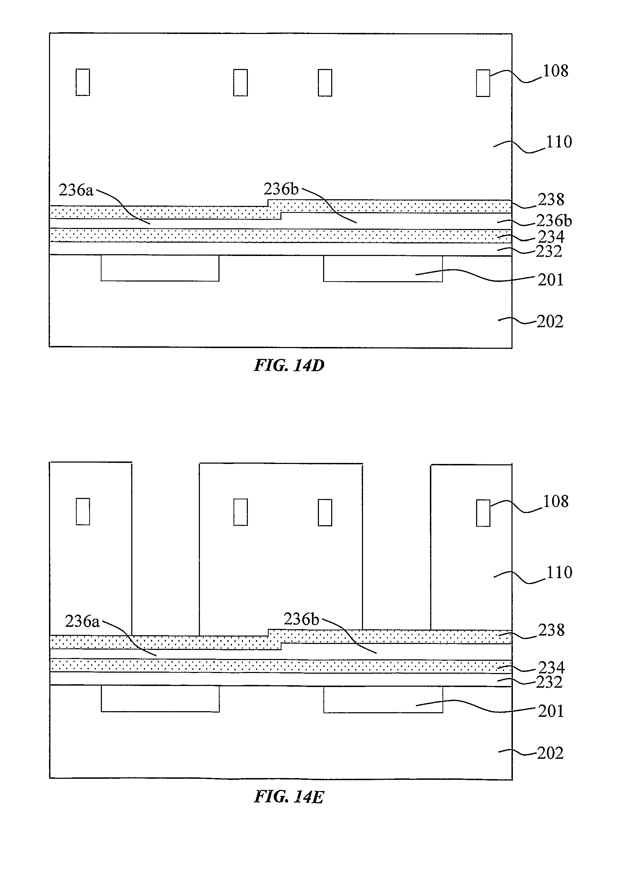

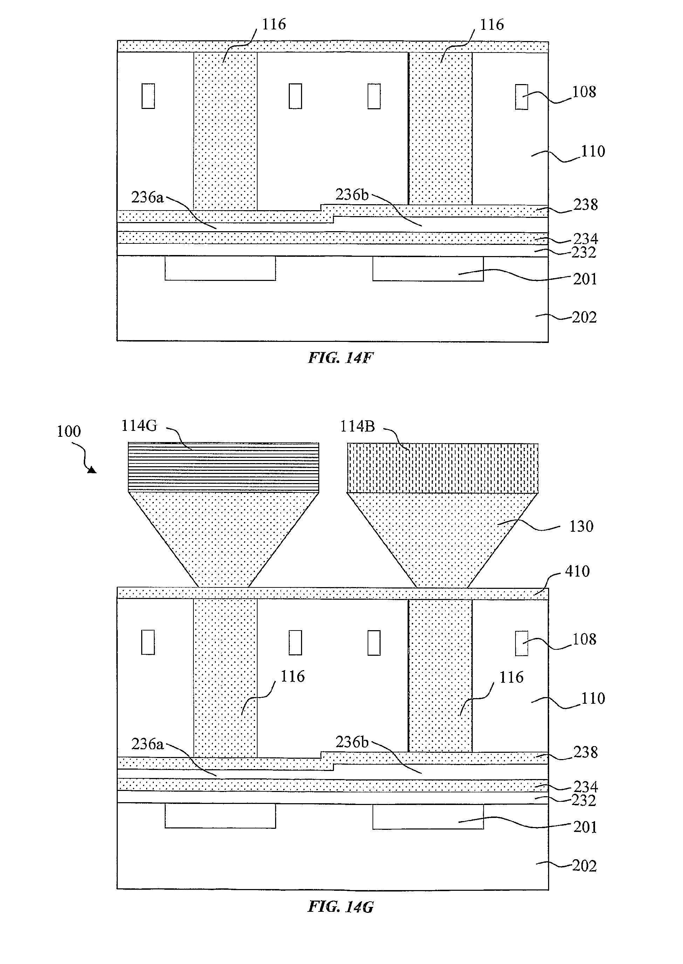

Figures 14A-G show a process for fabricating another example of anti-reflection stack between the light guides 116 and substrate 202 to provide two different AR stacks at two different pixels that each optimizes for a different color region. Third and second AR film 232 and 234 are provided over the photoelectric conversion unit 201 in Fig. 14A, similar to the example shown in Fig. 12A. In Fig. 14A, the top AR film 236 is deposited to the thickness of thicker top AR film 236b shown in Fig. 14B. Subsequently a lithography mask (not shown) is applied to create mask openings over the pixels that use the thinner top AR film 236a. An etch step is applied to thin the top AR film 236 under the mask opening to the smaller thickness of top AR film 236a in Fig. 14B. Subsequent steps, shown in Figures 14C to 14G, are similar to Figs. 12B-E. Green color filters 114G may be applied on the pixels having the thinner top AR film 236a, whereas Blue and Red color filters on the pixels having the thicker top AR film 236b.

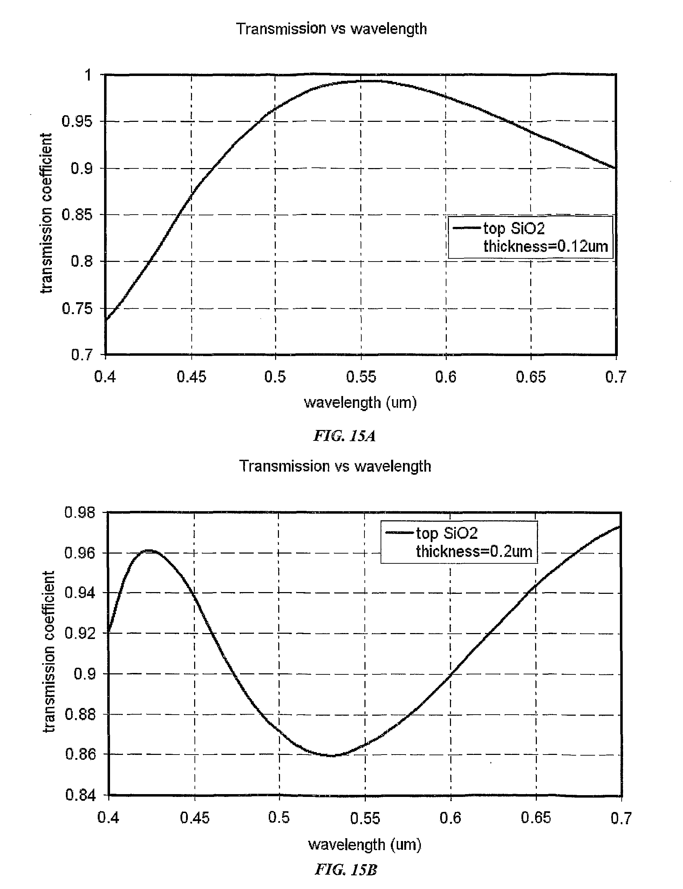

Figure 15A is a graph of transmission coefficient versus light wavelength for the anti-reflection stack of Fig. 14G for a thinner top AR film 236a of nominal thickness 0.12 um, a second AR film 234 of nominal thickness 500 Angstroms, and a third AR film 232 of nominal thickness 75 Angstroms (1 Angstrom = 0.1 nanometers). This graph peaks in the green color region at approximately 99%, and drops gently to approximately 93% at the center of the red color region. This graph shows that the thinner top AR film 236a can be used at red pixels as well as green pixels. This thinner top AR film 236a may be used at magenta pixels where magenta color is part of the mosaic pattern of the pixel array of the image sensor.

Figure 15B is a graph of transmission coefficient versus light wavelength for the anti-reflection stack of Fig. 14G for a thicker top AR film 236b of nominal thickness 0.20um, a second AR film 234 of nominal thickness 500 Angstroms, and a third AR film 232 of nominal thickness 75 Angstroms (1 Angstrom = 0.1 nanometers) . This graph peaks in two separate color regions, viz. purple and red. This graph shows that the top AR film 236b can be used at blue pixels and red pixels. This thicker top AR film 236b may be used at yellow pixels where yellow color is part of the mosaic pattern of the pixel array of the image sensor.

A pixel array may use the thinner top AR film 236a for green pixels only while the thicker top AR film 236b for both blue and red pixels. Alternately, the pixel array may use the thinner top AR film 236a for both green and red pixels while the thicker top AR film 236b for blue pixels only.

Another example to provide two different AR stacks that each optimizes for a different color region can be provided by creating different second AR film thicknesses while keeping the same top AR film thickness. Two different thicknesses are determined, one for each color region. For example, thicknesses of 2800 Angstrom and optimizes transmission for blue and red lights, whereas thickness of 650 Angstrom (1 Angstrom = 0.1 nanometers) optimizes for green lights. The second AR film is first deposited to the lager thickness. Subsequently a lithography mask is applied to create a mask opening over the pixels that uses the smaller second AR film thickness. An etching step is applied to thin the second AR film under the mask opening to the smaller thickness. Subsequent steps are identical to Figures 12B-E.

While certain exemplary embodiment has been described and shown in the accompanying drawings, it is to be understood that such embodiment is merely illustrative of and not restrictive on the broad invention, and that this invention not be limited to the specific constructions and arrangements shown and described, since various other modifications may occur to those ordinarily skilled in the art.

## Claims

1. An image sensor (100) that comprises a pair of adjacent image-sensor pixels on a substrate (106),
each pixel comprising:
a photoelectric conversion unit (102) supported by said substrate;
the image sensor further comprising
a sealing film (500) transparent to visible light,
wherein light rays enter from above said sealing film and impinge on said photoelectric conversion unit (102); and
each pixel comprising
a color filter (114B, 114G) wholly under said sealing film;
the image sensor further comprising an air gap (422) containing air or a gas,
said air gap being on a lateral side of and between the color filters (114B, 114G) of the pair of adjacent pixels, and under said sealing film (422);
**characterized in that**
a surface of said sealing film is concave at the boundary (510) with the air gap which is under said surface, such that it diverges into said color filters (114B, 114G) light rays that enter said air gap from said sealing film.

2. An image sensor as claimed in claim 1, wherein each pixel comprises a light guide below said color filter, wherein a plurality of light rays entering said light guide from above said sealing film cross only flat interfaces.

3. An image sensor as claimed in claims 1 or 2, further comprising a cover glass (810) above the image sensor (100), and
a transparent adhesive film (820) disposed between the cover glass (810) and the image
sensor (100) and constituting together with the sealing film (500) a transparent film filling the space between the cover glass (810) and the color filters (114B, 114G).

4. A method for fabricating an image sensor that comprises a pair of adjacent image-sensor pixels, comprising:
forming a support film (134) with a pair of adjacent openings (132) over a substrate (106) that supports a pair of photoelectric conversion units (102);
forming a color filter (114B, 114G) in each opening of the support film; removing from above a portion (212) of said support film adjacent to a lateral side of said color filters (114B, 114G) to form an air gap (422) adjacent the lateral side of and between the color filters (114B, 114G) of the pair of adjacent pixels;
forming a sealing film (500) on the color filters (114B, 114G) and the air gap (422), the sealing film (500) sealing air or a gas in the air gap (422) from above,
the method **characterized in that** the sealing film (500) is formed by a dynamic spin coating and **in that** the method further comprises
forming a concave surface on the sealing film (500), at the boundary (510) with the air gap which is under the surface, such that it diverges into said color filters (114B, 114G) light rays that enter said air gap (422) from said sealing film (500).

## Patentansprüche

1. Bildsensor (100), der zwei benachbarte Bildsensorpixel auf einer Substrat (106) umfasst, wobei jedes Pixel umfasst:
eine photoelektrische Umwandlungseinheit (102), die von der Substrat getragen wird;
wobei der Bildsensor ferner umfasst:
einen Versiegelungsfilm (500), der für sichtbares Licht transparent ist,
wobei Lichtstrahlen von oberhalb des Versiegelungsfilms eindringen und auf die photoelektrische Umwandlungseinheit (102) fallen; und
jedes Pixel ein Farbfilter (114B, 114G) zur Gänze unter dem Versiegelungsfilm umfasst;
der Bildsensor ferner einen Luftspalt (422) umfasst, der Luft oder ein Gas enthält, wobei der Luftspalt an einer lateralen Seite des und zwischen den Farbfiltern (114B, 114G) benachbarter Pixel und unter dem Versiegelungsfilm (422) liegt;
**dadurch gekennzeichnet, dass**
eine Oberfläche des Versiegelungsfilms an der Grenze (510) mit dem Luftspalt, der sich unter der Oberfläche befindet, konkav ist, so dass sie in die Farbfilter (114B, 114G) Lichtstrahlen divergiert, die von dem Versiegelungsfilm in den Luftspalt eindringen.

2. Bildsensor nach Anspruch 1, wobei jedes Pixel einen Lichtleiter unter dem Farbfilter umfasst, wobei mehrere Lichtstrahlen, die in den Lichtleiter von oberhalb des Versiegelungsfilms eindringen, nur flache Grenzflächen queren.

3. Bildsensor nach Anspruch 1 oder 2, ferner umfassend
ein Deckglas (810) über dem Bildsensor (100) und
einen transparenten Klebefilm (820) zwischen dem Deckglas (810) und dem Bildsensor (100), der gemeinsam mit dem Versiegelungsfilm (500) einen transparenten Film bildet, der den Raum zwischen dem Deckglas (810) und den Farbfiltern (114B, 114G) füllt.

4. Verfahren zum Herstellen eines Bildsensors, der zwei benachbarte Bildsensorpixel umfasst, umfassend:
Bilden eines Trägerfilms (134) mit zwei benachbarten Öffnungen (132) über einer Substrat (106), die zwei photoelektrische Umwandlungseinheiten (102) trägt;
Bilden eines Farbfilters (114B, 114G) in jeder Öffnung des Trägerfilms;
Entfernen von oben eines Abschnitts (212) des Trägerfilms neben einer lateralen Seite der Farbfilter (114B, 114G) zur Bildung eines Luftspalts (422) neben der lateralen Seite und zwischen den Farbfiltern (114B, 114G);
Bilden eines Versiegelungsfilms (500) auf den Farbfiltern (114B, 114G) und des Luftspalts (422), wobei der Versiegelungsfilm (500) Luft oder Gas in dem Luftspalt (422) von oben versiegelt,
wobei das Verfahren **dadurch gekennzeichnet ist, dass** der Versiegelungsfilm (500) durch dynamische Rotationsbeschichtung gebildet wird, und dass das Verfahren ferner umfasst:
Bilden einer konkaven Oberfläche auf dem Versiegelungsfilm (500), an der Grenze (510) mit dem Luftspalt, der sich unter der Oberfläche befindet, so dass er in die Farbfilter (114B, 114G) Lichtstrahlen divergiert, die von dem Versiegelungsfilm (500) in den Luftspalt (422) eindringen.

## Revendications

1. Capteur d'image (100) qui comprend une paire de pixels de capteur d'image adjacents sur un substrat (106), chaque pixel comprenant :
une unité de conversion photoélectrique (102) supportée par ledit substrat ;
le capteur d'image comprenant en outre :
un film d'étanchéité (500) transparent à la lumière visible, des rayons de lumière qui entrent par le dessus dudit film d'étanchéité heurtant ladite unité de conversion photoélectrique (102) ; et
chaque pixel comprenant un filtre de couleur (114B, 114G) entièrement au-dessous dudit film d'étanchéité ;
le capteur d'image comprenant en outre un entrefer (422) contenant de l'air ou un gaz, ledit entrefer étant sur un côté latéral de et entre les filtres de couleur (114B, 114G) de pixels adjacents, et au-dessous dudit film d'étanchéité (422) ;
**caractérisé en ce que**
une surface dudit film d'étanchéité est concave à la frontière (510) avec l'entrefer, qui est au-dessous de ladite surface, de manière à faire diverger, dans lesdits filtres de couleur (114B, 114G), les rayons de lumière qui entrent dans ledit entrefer à partir dudit film d'étanchéité.

2. Capteur d'image selon la revendication 1, dans lequel chaque pixel comprend un guide lumineux au-dessous dudit filtre de couleur, dans lequel une pluralité de rayons de lumière qui entrent dans ledit guide lumineux par le dessus dudit film d'étanchéité traverse des interfaces plates seulment.

3. Capteur d'image selon la revendication 1 ou 2, comprenant en outre :
un verre de recouvrement (810) au-dessus du capteur d'image (100), et
un film adhésif transparent (820) disposé entre le verre de recouvrement (810) et le capteur d'image (100) et constituant, avec le film d'étanchéité (500), un film transparent remplissant l'espace entre le verre de recouvrement (810) et les filtres de couleur (114B, 114G).

4. Procédé de fabrication d'un capteur d'image qui comprend une paire de pixels de capteur d'image adjacents, comprenant :
la formation d'un film de support (134) avec une paire d'ouvertures adjacentes (132) au-dessus d'un substrat (106) qui supporte une paire d'unités de conversion photoélectrique (102) ;
la formation d'un filtre de couleur (114B, 114G) dans chaque ouverture du film de support ;
l'enlèvement, par le dessus, d'une portion (212) dudit film de support adjacente à un côté latéral desdits filtres de couleur (114B, 114G) pour former un entrefer (422) adjacent au côté latéral et entre les filtres de couleur (114B, 114G) ;
la formation d'un film d'étanchéité (500) sur les filtres de couleur (114B, 114G) et l'entrefer (422), le film d'étanchéité (500) scellant l'air ou un gaz dans l'entrefer (422) par le dessus,
le procédé étant **caractérisé en ce que** le film d'étanchéité (500) est formé par revêtement par centrifugation dynamique et **en ce que** le procédé comprend en outre :
la formation d'une surface concave sur le film d'étanchéité (500), à la frontière (510) avec l'entrefer, qui est au-dessous de la surface, de manière à faire diverger, dans lesdits filtres de couleur (114B, 114G), les rayons de lumière qui entrent dans ledit entrefer (422) à partir dudit film d'étanchéité (500).
